# EUROPEAN PATENT APPLICATION

(11) **EP 4 542 651 A1**
(43) Date of publication of application: **23.04.2025**
(21) Application number: 22951236.3
(22) Date of filing: 15.07.2022
(51) Int. Cl.: H01L 27/15, H01L 25/075, H01L 33/62, H01L 33/48, H01L 33/38

(54) **SEMICONDUCTOR LIGHT-EMITTING DEVICE PACKAGE AND DISPLAY DEVICE**

(71) Applicant: LG Electronics Inc., Yeongdeungpo-gu Seoul 07336 (KR)
(72) Inventor: KIM, Myoungsoo, Seoul 06772 (KR); JEON, Jina, Seoul 06772 (KR); PARK, Sungjin, Seoul 06772 (KR); OH, Taesu, Seoul 06772 (KR); KIM, Jungsub, Seoul 06772 (KR)
(74) Representative: Vossius & Partner Patentanwälte Rechtsanwälte mbB
(86) International application number: PCT/KR2022/010346
(87) International publication number: WO 2024/014581

(57) **Abstract**

A semiconductor light-emitting element package may include a semiconductor substrate having a first region and a second region, a first semiconductor light-emitting element on the first region of the semiconductor substrate, a pair of assembling wirings on the second region of the semiconductor substrate, and a second semiconductor light-emitting element and a third semiconductor light-emitting element on the pair of assembling wirings.

## Description

### [Technical Field]

The embodiment relates to a semiconductor light-emitting element package and a display device.

### [Background Art]

A large-area display includes a liquid crystal display (LCD), an OLED display, and a micro-LED display.

A micro-LED display is a display that uses micro-LEDs, which are semiconductor light-emitting elements with a diameter or cross-sectional area of 100*µ*m or less, as display elements.

Since a micro-LED display uses micro-LEDs, which are semiconductor light-emitting elements, as display elements, it has excellent performance in many characteristics such as contrast ratio, response speed, color reproducibility, viewing angle, brightness, resolution, lifespan, luminous efficiency, and luminance.

In particular, a micro-LED display has an advantage of being able to freely adjust the size or resolution by separating and combining the screen in a modular manner, and the advantage of being able to implement a flexible display.

However, since a large micro-LED display requires millions or more micro-LEDs, there is a technical problem in quickly and accurately transferring micro-LEDs to a display panel.

Recently developed transfer technologies include the pick and place process, the laser lift-off method, or the self-assembly method.

Among these, the self-assembly method is a method in which semiconductor light-emitting elements find their assembly positions within a fluid, which is advantageous for implementing a large-screen display device.

However, research on the technology for manufacturing a display device through self-assembly of micro-LEDs is still insufficient.

In particular, in the case of rapidly transferring millions or more semiconductor light-emitting elements to a large display device in a conventional technology, the transfer speed may be improved, but the transfer error rate may increase, which has a technical problem in that the transfer yield decreases.

In the related technology, a self-assembly transfer process using dielectrophoresis (DEP) is attempted, but there is a problem that the self-assembly rate is low due to the non-uniformity of the DEP force.

On the other hand, in the self-assembly method, since the red light-emitting element, the green light-emitting element, and the blue light-emitting element are individually put into, assembled, and recovered, there is a problem that the process time is very long. In addition, when a light-emitting element that was not recovered in the previous process is assembled with another light-emitting element, a light-emitting element that emits light of a different color in a specific color area is assembled, so that there was a problem that color mixing occurred and it was difficult to implement full color.

On the other hand, since the red light-emitting element, the green light-emitting element, and the blue light-emitting element must be disposed in the pixel of the display substrate, it is difficult to reduce the size of the pixels, making it difficult to implement ultra-high resolution.

### [Disclosure]

### [Technical Problem]

An object of the embodiment is to solve the foregoing and other problems.

Another object of the embodiment is to provide a light-emitting element package and a display device capable of improving the assembly speed.

In addition, another object of the embodiment is to provide a light-emitting element package and a display device capable of preventing color mixing defects.

In addition, another object of the embodiment is to provide a light-emitting element package and a display device capable of implementing ultra-high resolution.

The technical problems of the embodiments are not limited to those described in this item and include those that may be understood through the description of the invention.

### [Technical Solution]

According to one aspect of the embodiment, to achieve the above or other objects, a semiconductor light-emitting element package, comprising: a semiconductor substrate having a first region and a second region; a first semiconductor light-emitting element on the first region of the semiconductor substrate; a pair of assembling wirings on the second region of the semiconductor substrate; and a second semiconductor light-emitting element and a third semiconductor light-emitting element on the pair of assembling wirings.

The semiconductor substrate may share a first conductivity-type semiconductor layer of the first semiconductor light-emitting element.

The semiconductor substrate may have a third region, and the second region may be positioned between the first region and the third region. In this instance, the semiconductor light-emitting element package may comprise a fourth semiconductor light-emitting element on the third region of the semiconductor substrate; and a fifth semiconductor light-emitting element and a sixth semiconductor light-emitting element on the pair of assembling wirings.

The first semiconductor light-emitting element and the fourth semiconductor light-emitting element may be blue semiconductor light-emitting elements, the second semiconductor light-emitting element and the fifth semiconductor light-emitting element may be green semiconductor light-emitting elements, and the third semiconductor light-emitting element and the sixth semiconductor light-emitting element may be red semiconductor light-emitting elements.

The first semiconductor light-emitting element, the second semiconductor light-emitting element, and the third semiconductor light-emitting element may constitute a first pixel, and the fourth semiconductor light-emitting element, the fifth semiconductor light-emitting element, and the sixth semiconductor light-emitting element may constitute a second pixel.

The first semiconductor light-emitting element, the second semiconductor light-emitting element, and the third semiconductor light-emitting element may constitute a pixel, and the fourth semiconductor light-emitting element, the fifth semiconductor light-emitting element, and the sixth semiconductor light-emitting element may constitute a dummy pixel.

The third semiconductor light-emitting element and the sixth semiconductor light-emitting element may be disposed between the second semiconductor light-emitting element and the fifth semiconductor light-emitting element.

The third semiconductor light-emitting element and the sixth semiconductor light-emitting element may be symmetrical to each other with respect to a lengthwise direction of the pair of assembling wirings.

The third semiconductor light-emitting element may be disposed on a first assembling wiring of the pair of assembling wirings, and the sixth semiconductor light-emitting element may be disposed on a second assembling wiring of the pair of assembling wirings.

A first conductivity-type semiconductor layer of the third semiconductor light-emitting element and a first conductivity-type semiconductor layer of the sixth semiconductor light-emitting element may be connected.

The semiconductor light-emitting element package may comprise a first common pad commonly connected to a first upper side of each of the first semiconductor light-emitting element, the second semiconductor light-emitting element, and the third semiconductor light-emitting element; and a first electrode pad extending horizontally in a direction of a second upper side of the first semiconductor light-emitting element on a second upper side of the third semiconductor light-emitting element.

The semiconductor light-emitting element package may comprise a second common pad commonly connected to a first upper side of each of the fourth semiconductor light-emitting element, the fifth semiconductor light-emitting element, and the sixth semiconductor light-emitting element; and a second electrode pad extending horizontally in a direction of a second upper side of the fourth semiconductor light-emitting element on a second upper side of the sixth semiconductor light-emitting element.

The first common pad and the second common pad may be positioned diagonally.

The semiconductor light-emitting element package may comprise a first insulation layer between the second region of the semiconductor substrate and the pair of assembling wirings; a second insulation layer around each of the second semiconductor light-emitting element, the third semiconductor light-emitting element, the fifth semiconductor light-emitting element, and the sixth semiconductor light-emitting element; and a third insulation layer on the first to sixth semiconductor light-emitting elements.

Each of the second semiconductor light-emitting element, the third semiconductor light-emitting element, the fifth semiconductor light-emitting element, and the sixth semiconductor light-emitting element may comprise a magnetic layer.

The pair of assembling wirings may comprise a magnetic layer.

According to another aspect of the embodiment, a display device, comprising: a display substrate comprising a plurality of pixels; a pair of first assembling wirings corresponding to each of the plurality of pixels; a partition wall comprising an assembly hole on the pair of first assembling wirings; a semiconductor light-emitting element package in the assembly hole; wherein the semiconductor light-emitting element package comprises: a semiconductor substrate having a first region and a second region; a first semiconductor light-emitting element on the first region of the semiconductor substrate; a pair of second assembling wirings on the second region of the semiconductor substrate; and a second semiconductor light-emitting element and a third semiconductor light-emitting element on the pair of second assembling wirings.

### [Advantageous Effects]

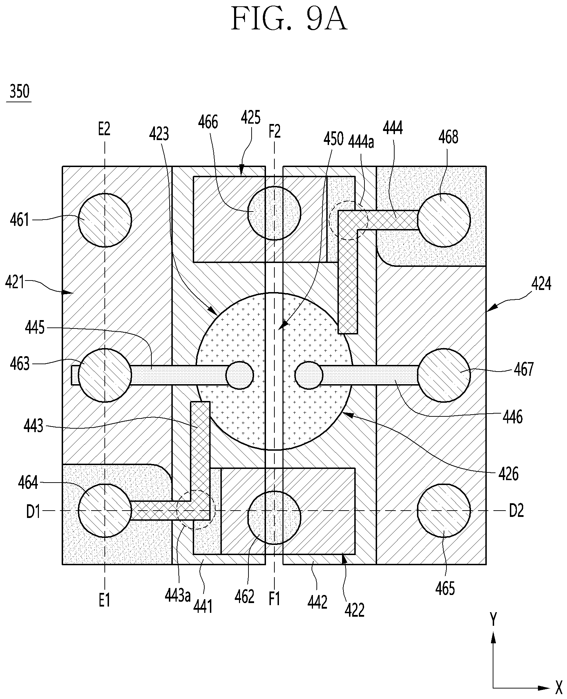

As illustrated in FIG. 9A, a semiconductor light-emitting element package 350 comprising a plurality of semiconductor light-emitting elements 421, 422, and 423 capable of displaying an image is assembled on a display substrate 310 using a self-assembly method, so that it is possible to prevent assembly defects that occur by individually assembling semiconductor light-emitting elements and to dramatically improve assembly speed.

When the semiconductor light-emitting elements are individually assembled, a color mixing defect occurs because the semiconductor light-emitting elements are assembled in different assembly holes. However, as in the embodiment, the color mixing defect may be prevented by assembling the semiconductor light-emitting element package 350 comprising a plurality of semiconductor light-emitting elements 421, 422, and 423.

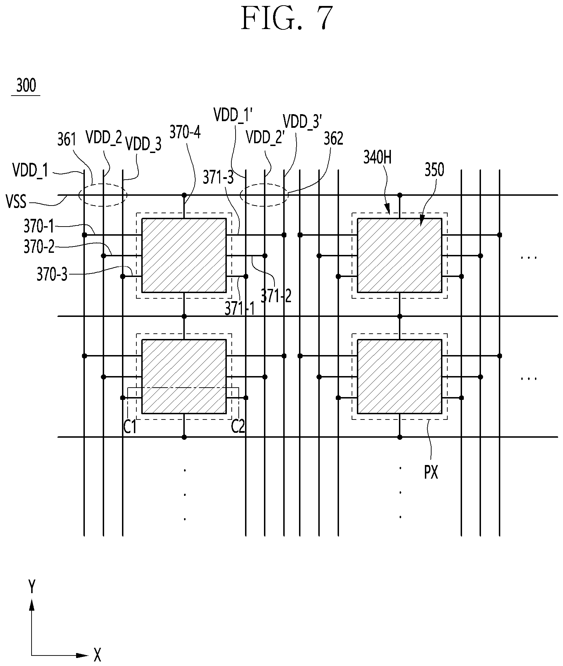

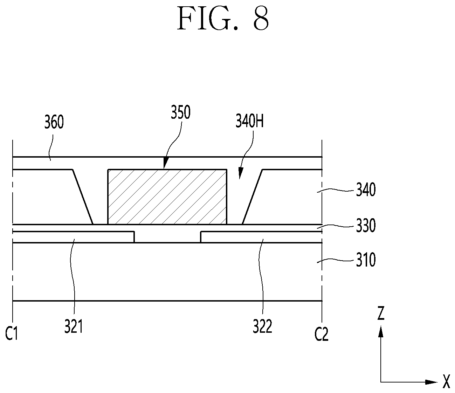

When the semiconductor light-emitting elements are individually assembled, assembly holes for assembling these semiconductor light-emitting elements are provided on the display substrate. In this instance, it is difficult to implement high resolution because a minimum separation distance between the assembly holes is required. However, as in the embodiment, a semiconductor light-emitting element package 350 comprising a plurality of semiconductor light-emitting elements 421 to 426 is manufactured using a semiconductor process, thereby reducing the separation distance between the semiconductor light-emitting elements 421 to 426. As such, a display device (300 of FIGS. 7 and 8) may be manufactured based on the semiconductor light-emitting element package 350 in which the separation distance between the semiconductor light-emitting elements 421 to 426 is reduced, thereby implementing ultra-high resolution.

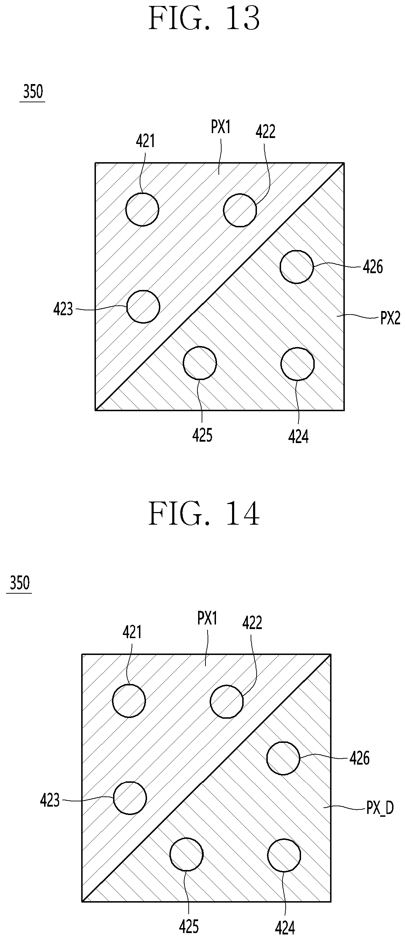

Meanwhile, the semiconductor light-emitting element package 350 of the embodiment may further improve the resolution by comprising a plurality of semiconductor light-emitting elements 421 to 426 to form two pixels PX1 and PX2, as illustrated in FIG. 13.

In addition, as illustrated in FIG. 14, the semiconductor light-emitting element package 350 of the embodiment may comprise a plurality of semiconductor light-emitting elements 421 to 426 to form one pixel PX and a dummy pixel PX_D, so that even if the semiconductor light-emitting elements 421 to 423 in the pixel PX fail, they may be replaced with the semiconductor light-emitting elements 424 to 426 in the dummy pixel PX D, thereby significantly improving the yield.

Additional scope of applicability of the embodiments will become apparent from the detailed description that follows. However, since various changes and modifications within the idea and scope of the embodiments may be clearly understood by those skilled in the art, the detailed description and specific embodiments, such as preferred embodiments, should be understood as being given by way of example only.

### [Description of Drawings]

FIG. 1 illustrates a living room of a house in which a display device according to an embodiment is disposed.
FIG. 2 is a block diagram schematically showing a display device according to an embodiment.
FIG. 3 is a circuit diagram showing an example of a pixel of FIG. 2.
FIG. 4 is an enlarged view of a first panel region in the display device of FIG. 1.
FIG. 5 is an enlarged view of area A2 of FIG. 4.
FIG. 6 is a drawing showing an example in which a light-emitting element according to an embodiment is assembled to a substrate by a self-assembly method.
FIG. 7 is a drawing illustrating a display device according to an embodiment.
FIG. 8 is a cross-sectional view schematically illustrating a display device according to an embodiment.
FIG. 9A is a plan view illustrating a semiconductor light-emitting element package according to an embodiment.
FIG. 9B is a bottom view illustrating a semiconductor light-emitting element package according to an embodiment.
FIG. 10A is a cross-sectional view taken along line D1-D2 in the semiconductor light-emitting element package according to the embodiment of FIG. 9A.
FIG. 10B is a cross-sectional view taken along line E1-E2 in the semiconductor light-emitting element package according to the embodiment of FIG. 9A.
FIG. 10C is a cross-sectional view taken along line F1-F2 in the semiconductor light-emitting element package according to the embodiment of FIG. 9A.
FIG. 11A is a plan view illustrating a third semiconductor light-emitting element and a sixth semiconductor light-emitting element.
FIG. 11B is a cross-sectional view illustrating a third semiconductor light-emitting element and a sixth semiconductor light-emitting element.
FIG. 12 illustrates a plurality of semiconductor light-emitting element packages manufactured on a wafer.
FIG. 13 illustrates two pixels configured by the first to sixth semiconductor light-emitting elements.
FIG. 14 illustrates one pixel and one dummy pixel configured by the first to sixth semiconductor light-emitting elements.
FIGS. 15 to 34 illustrate a manufacturing process of a semiconductor light-emitting element package according to an embodiment.
FIGS. 35A and 35B illustrate a process of manufacturing a display device using a transfer method based on a semiconductor light-emitting element package according to an embodiment.

The sizes, shapes, dimensions, etc. of elements illustrated in the drawings may differ from actual ones. In addition, even if the same elements are illustrated in different sizes, shapes, dimensions, etc. between the drawings, this is only an example on the drawing, and the same elements have the same sizes, shapes, dimensions, etc. between the drawings.

### [Mode for Invention]

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there may be directly on the other element or be other intermediate elements therebetween.

The display device described in this specification may comprise a TV, a signage, a mobile phone, a smart phone, a head-up display (HUD) for an automobile, a backlight unit for a laptop computer, a display for VR or AR, etc. However, the configuration according to the embodiment described in this specification may be applied to a device capable of displaying, even if it is a new product type developed in the future.

The following describes a light-emitting element according to an embodiment and a display device comprising the same.

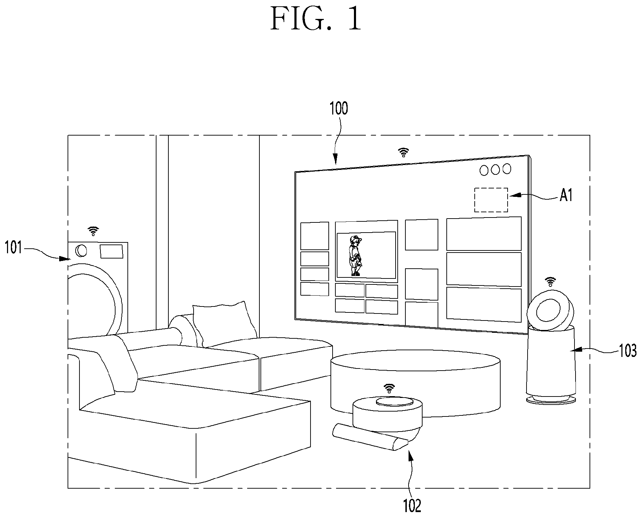

FIG. 1 illustrates a living room of a house in which a display device according to an embodiment is disposed.

Referring to FIG. 1, the display device 100 according to the embodiment may display the status of various electronic products such as a washing machine 101, a robot vacuum cleaner 102, and an air purifier 103, and may communicate with each electronic product based on IOT and control each electronic product based on user setting data.

The display device 100 according to the embodiment may comprise a flexible display manufactured on a thin and flexible substrate. The flexible display may be bent or rolled like paper while maintaining the characteristics of an existing flat panel display.

In the flexible display, visual information may be implemented by independently controlling the light emission of unit pixels disposed in a matrix form. A unit pixel means a minimum unit for implementing one color. The unit pixel of the flexible display may be implemented by a light-emitting element. In the embodiment, the light-emitting element may be a micro-LED or a nano-LED, but is not limited thereto.

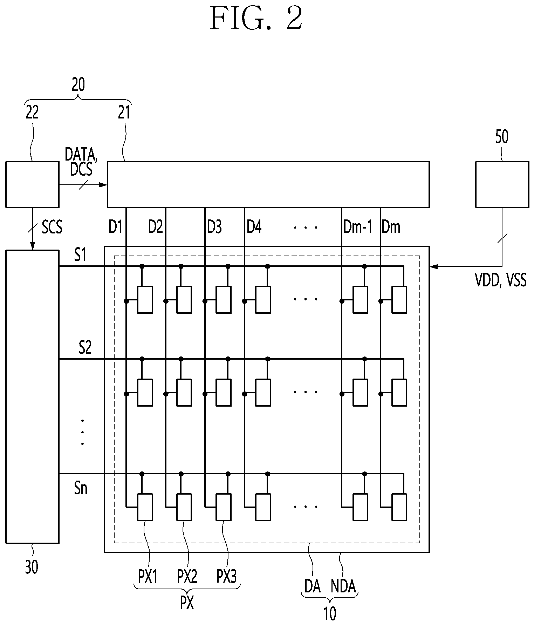

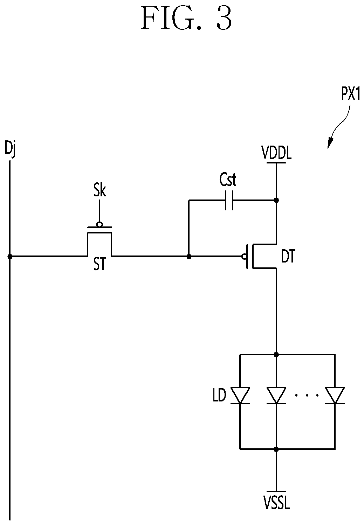

FIG. 2 is a block diagram schematically showing a display device according to an embodiment, and FIG. 3 is a circuit diagram showing an example of a pixel of FIG. 2.

Referring to FIGS. 2 and 3, the display device according to the embodiment may comprise a display panel 10, a driving circuit 20, a scan driving unit 30, and a power supply circuit 50.

The display device 100 of the embodiment may drive the light-emitting element in an active matrix (AM) method or a passive matrix (PM) method.

The driving circuit 20 may comprise a data driving unit 21 and a timing control unit 22.

The display panel 10 may be formed in a rectangular shape, but is not limited thereto. That is, the display panel 10 may be formed in a circular or oval shape. At least one side of the display panel 10 may be formed to be bent at a predetermined curvature.

The display panel 10 may be divided into a display area DA and a non-display area NDA disposed around the display area DA. The display area DA is an area where pixels PX are formed to display an image. The display panel 10 may comprise data lines (D1 to Dm, m is an integer greater than or equal to 2), scan lines (S1 to Sn, n is an integer greater than or equal to 2) crossing the data lines D1 to Dm, a high-potential voltage line VDDL to which a high-potential voltage is supplied, a low-potential voltage line VSSL to which a low-potential voltage is supplied, and pixels PX connected to the data lines D1 to Dm and the scan lines S1 to Sn.

Each of the pixels PX may comprise a first sub-pixel PX1, a second sub-pixel PX2, and a third sub-pixel PX3. The first sub-pixel PX1 may emit a first color light of a first main wavelength, the second sub-pixel PX2 may emit a second color light of a second main wavelength, and the third sub-pixel PX3 may emit a third color light of a third main wavelength. The first color light may be red light, the second color light may be green light, and the third color light may be blue light, but are not limited thereto. In addition, although it is exemplified that each of the pixels PX comprises three sub-pixels in FIG. 2, it is not limited thereto. That is, each of the pixels PX may comprise four or more sub-pixels.

Each of the first sub-pixel PX1, the second sub-pixel PX2, and the third sub-pixel PX3 may be connected to at least one of the data lines D1 to Dm, at least one of the scan lines S1 to Sn, and the high-potential voltage line VDDL. The first sub-pixel PX1 may comprise light-emitting elements LD, a plurality of transistors for supplying current to the light-emitting elements LD, and at least one capacitor Cst, as illustrated in FIG. 3.

Although not illustrated in the drawing, each of the first sub-pixel PX1, the second sub-pixel PX2, and the third sub-pixel PX3 may comprise only one light-emitting element LD and at least one capacitor Cst.

Each of the light-emitting elements LD may be a semiconductor light-emitting diode comprising a first electrode, a plurality of conductivity-type semiconductor layers, and a second electrode. Here, the first electrode may be an anode electrode, and the second electrode may be a cathode electrode, but are not limited thereto.

The light-emitting element LD may be one of a lateral-type light-emitting element, a flip-chip type light-emitting element, and a vertical-type light-emitting element.

The plurality of transistors may comprise a driving transistor DT for supplying current to the light-emitting elements LD, and a scan transistor ST for supplying a data voltage to a gate electrode of the driving transistor DT, as illustrated in FIG. 3. The driving transistor DT may comprise a gate electrode connected to a source electrode of the scan transistor ST, a source electrode connected to a high-potential voltage line VDDL to which a high-potential voltage is applied, and a drain electrode connected to the first electrodes of the light-emitting elements LD. The scan transistor ST may comprise a gate electrode connected to a scan line (Sk, where k is an integer satisfying 1 ≤ k ≤ n), a source electrode connected to the gate electrode of the driving transistor DT, and a drain electrode connected to a data line (Dj, where j is an integer satisfying 1 ≤ j ≤ m).

The capacitor Cst is formed between the gate electrode and the source electrode of the driving transistor DT. The storage capacitor Cst charges the difference between a gate voltage and a source voltage of the driving transistor DT.

The driving transistor DT and the scan transistor ST may be formed as thin film transistors. In addition, in FIG. 3, the driving transistor DT and the scan transistor ST are described mainly as being formed as P-type metal oxide semiconductor field effect transistors (MOSFETs), but the present invention is not limited thereto. The driving transistor DT and the scan transistor ST may also be formed as N-type MOSFETs. In this instance, the positions of the source electrodes and the drain electrodes of each of the driving transistor DT and the scan transistor ST may be changed.

In addition, in FIG. 3, it is exemplified that the first sub-pixel PX1, the second sub-pixel PX2, and the third sub-pixel PX3 each comprise a 2T1C (2 transistor - 1 capacitor) having one driving transistor DT, one scan transistor ST, and one capacitor Cst, but the present invention is not limited thereto. The first sub-pixel PX1, the second sub-pixel PX2, and the third sub-pixel PX3 each may comprise a plurality of scan transistors STs and a plurality of capacitors Cst.

The second sub-pixel PX2 and the third sub-pixel PX3 may be expressed in substantially the same circuit diagram as the first sub-pixel PX1, so a detailed description thereof will be omitted.

The driving circuit 20 outputs signals and voltages for driving the display panel 10. To this end, the driving circuit 20 may comprise a data driving unit 21 and a timing control unit 22.

The timing control unit 22 receives digital video data DATA and timing signals from a host system. The timing signals may comprise a vertical synchronization signal, a horizontal synchronization signal, a data enable signal, and a dot clock. The host system may be an application processor of a smartphone or tablet PC, a monitor, a system on chip of a TV, etc.

The timing control unit 22 generates control signals for controlling the operation timing of the data driving unit 21 and the scan driving unit 30. The control signals may comprise a source control signal DCS for controlling the operation timing of the data driving unit 21 and a scan control signal SCS for controlling the operation timing of the scan driving unit 30.

The scan driving unit 30 receives the scan control signal SCS from the timing control unit 22. The scan driving unit 30 generates scan signals according to the scan control signal SCS and supplies them to the scan lines S1 to Sn of the display panel 10. The scan driving unit 30 may be formed in the non-display area NDA of the display panel 10 comprising a plurality of transistors. Alternatively, the scan driving unit 30 may be formed as an integrated circuit, in which case it may be mounted on a gate flexible film attached to the other side of the display panel 10.

The data driving unit 21 receives digital video data DATA and a source control signal DCS from the timing control unit 22. The data driving unit 21 converts the digital video data DATA into analog data voltages according to the source control signal DCS and supplies them to the data lines D1 to Dm of the display panel 10.

The power supply circuit 50 may generate voltages necessary for driving the display panel 10 from a main power applied from a system board and supply them to the display panel 10. For example, the power supply circuit 50 may generate a high-potential voltage VDD and a low-potential voltage VSS for driving the light-emitting elements LD of the display panel 10 from a main power supply and supply them to the high-potential voltage line VDDL and the low-potential voltage line VSSL of the display panel 10. In addition, the power supply circuit 50 may generate and supply driving voltages for driving the driving circuit 20 and the scan driving unit 30 from the main power supply.

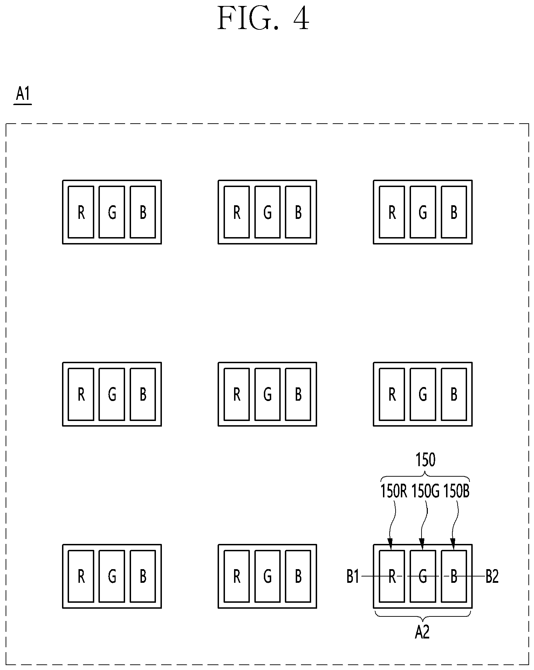

FIG. 4 is an enlarged view of the first panel region in the display device of FIG. 3.

Referring to FIG. 4, the display device 100 of the embodiment may be manufactured by mechanically and electrically connecting a plurality of panel regions such as the first panel region A1 by tiling.

Alternatively, the plurality of panel regions may be configured as a single display panel formed integrally.

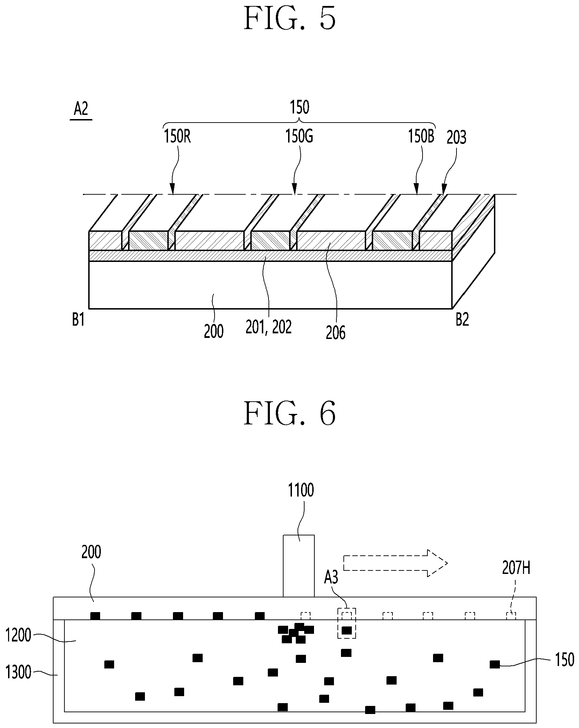

FIG. 5 is an enlarged view of area A2 of FIG. 4.

Referring to FIG. 5, the display device 100 of the embodiment may comprise a substrate 200, assembling wiring 201 and 202, an insulation layer 206, and a plurality of semiconductor light-emitting elements 150. More components may be included than these.

The assembling wiring may comprise a first assembling wiring 201 and a second assembling wiring 202 that are spaced apart from each other. The first assembling wiring 201 and the second assembling wiring 202 may be provided to generate a dielectrophoretic force (DEP force) to assemble the semiconductor light-emitting element 150. For example, the semiconductor light-emitting element 150 may be one of a lateral-type semiconductor light-emitting element, a flip-chip type semiconductor light-emitting element, and a vertical-type semiconductor light-emitting element.

The semiconductor light-emitting element 150 may comprise, but is not limited to, a red semiconductor light-emitting element 150, a green semiconductor light-emitting element 150G, and a blue semiconductor light-emitting element 150B to form a unit pixel, and may also comprise a red phosphor and a green phosphor to implement red and green, respectively.

The substrate 200 may be a support member that supports components disposed on the substrate 200, or a protective member that protects the components.

The substrate 200 may be a rigid substrate or a flexible substrate. The substrate 200 may be formed of sapphire, glass, silicon, or polyimide. In addition, the substrate 200 may comprise a flexible material such as polyethylene naphthalate (PEN), polyethylene terephthalate (PET). In addition, the substrate 200 may be a transparent material, but is not limited thereto. The substrate 200 may function as a support substrate in the display panel, and may also function as an assembly substrate when self-assembling the light-emitting elements.

The substrate 200 may be a backplane equipped with circuits, such as transistors ST and DT, capacitors Cst, and signal wirings, within the sub-pixels PX1, PX2, and PX3 illustrated in FIGS. 2 and 3, but is not limited thereto.

The insulation layer 206 may comprise an organic material having insulation and flexibility, such as polyimide, PAC, PEN, PET, polymer, or an inorganic material, such as silicon oxide (SiO₂) or silicon nitride series (SiNx), and may be formed integrally with the substrate 200 to form a single substrate.

The insulation layer 206 may be a conductive adhesive layer having adhesiveness and conductivity, and the conductive adhesive layer may have flexibility to enable a flexible function of the display device. For example, the insulation layer 206 may be an anisotropic conductive film (ACF) or a conductive adhesive layer such as an anisotropic conductive medium, a solution containing conductive particles, etc. The conductive adhesive layer may be a layer that is electrically conductive in a vertical direction relative to the thickness, but electrically insulating in a horizontal direction relative to the thickness.

The insulation layer 206 may comprise an assembly hole 203 for inserting the semiconductor light-emitting element 150. Therefore, during self-assembly, the semiconductor light-emitting element 150 may be easily inserted into the assembly hole 203 of the insulation layer 206. The assembly hole 203 may be called an insertion hole, a fixing hole, an alignment hole, etc. The assembly hole 203 may also be called a hole.

The assembly hole 203 may be called a hole, a groove, a recess, a pocket, etc.

The assembly hole 203 may vary depending on the shape of the semiconductor light-emitting element 150. For example, the red semiconductor light-emitting element, the green semiconductor light-emitting element, and the blue semiconductor light-emitting element each have different shapes, and may have an assembly hole 203 having a shape corresponding to the shape of each of these semiconductor light-emitting elements. For example, the assembly hole 203 may comprise a first assembly hole for assembling the red semiconductor light-emitting element, a second assembly hole for assembling the green semiconductor light-emitting element, and a third assembly hole for assembling the blue semiconductor light-emitting element. For example, the red semiconductor light-emitting element may have a circular shape, the green semiconductor light-emitting element may have a first oval shape having a first minor axis and a first major axis, and the blue semiconductor light-emitting element may have a second oval shape having a second minor axis and a second major axis, but are not limited thereto. The second major axis of the oval shape of the blue semiconductor light-emitting element may be larger than the first major axis of the oval shape of the green semiconductor light-emitting element, and the second minor axis of the oval shape of the blue semiconductor light-emitting element may be smaller than the first minor axis of the oval shape of the green semiconductor light-emitting element.

Meanwhile, the method of mounting the semiconductor light-emitting element 150 on the substrate 200 may comprise, for example, a self-assembly method (FIG. 6) and a transfer method.

FIG. 6 is a drawing showing an example of assembling a light-emitting element according to an embodiment on a substrate by a self-assembly method.

Based on FIG. 6, an example of assembling a semiconductor light-emitting element according to an embodiment on a display panel by a self-assembly method using an electromagnetic field will be described.

The assembly substrate 200 described below may also function as a display substrate 200a in a display device after assembly of a light-emitting element, but the embodiment is not limited thereto.

Referring to FIG. 6, the semiconductor light-emitting element 150 may be put into a chamber 1300 filled with a fluid 1200, and the semiconductor light-emitting element 150 may be moved to the assembly substrate 200 by a magnetic field generated from the assembly device 1100. At this time, the light-emitting element 150 adjacent to the assembly hole 207H of the assembly substrate 200 may be assembled into the assembly hole 207H by the DEP force caused by the electric field of the assembling wirings. The fluid 1200 may be water such as ultrapure water, but is not limited thereto. The chamber may be called a tank, a container, a vessel, etc.

After the semiconductor light-emitting element 150 is put into the chamber 1300, the assembly substrate 200 may be disposed on the chamber 1300. Depending on the embodiment, the assembly substrate 200 may also be put into the chamber 1300.

The semiconductor light-emitting element 150 may be a lateral-type semiconductor light-emitting element, a vertical-type semiconductor light-emitting element, or a flip-chip type semiconductor light-emitting element.

The semiconductor light-emitting element 150 may comprise a magnetic layer (not illustrated) having a magnetic substance. The magnetic layer may comprise a metal having magnetism, such as nickel (Ni). Since the semiconductor light-emitting element 150 put into the fluid comprises the magnetic layer, it may move to the assembly substrate 200 by a magnetic field generated from the assembly device 1100. The magnetic layer may be disposed on the upper side, lower side, or both sides of the light-emitting element.

The semiconductor light-emitting element 150 may comprise a passivation layer 156 surrounding an upper surface and a side surface thereof. The passivation layer 156 may be formed by using an inorganic insulator, such as silica or alumina, through PECVD, LPCVD, sputtering deposition, etc. In addition, the passivation layer 156 may be formed by a method of spin coating an organic material such as a photoresist or a polymer material.

The semiconductor light-emitting element 150 may comprise a first conductivity-type semiconductor layer, a second conductivity-type semiconductor layer, and an active layer disposed therebetween. The first conductivity-type semiconductor layer may be an n-type semiconductor layer, and the second conductivity-type semiconductor layer may be a p-type semiconductor layer, but are not limited thereto. The first conductivity-type semiconductor layer, the second conductivity-type semiconductor layer, and the active layer disposed therebetween may constitute a light-emitting portion. The light-emitting portion may be called a light-emitting layer, a light-emitting region, etc.

The first electrode (layer) may be disposed under the first conductivity-type semiconductor layer, and the second electrode (layer) may be disposed on the second conductivity-type semiconductor layer. To this end, a part of the first conductivity-type semiconductor layer or the second conductivity-type semiconductor layer may be exposed to the outside. Accordingly, after the semiconductor light-emitting element 150 is assembled on the assembly substrate 200, a part of the passivation layer may be etched in the manufacturing process of the display device.

The first electrode may comprise at least one or more layer. For example, the first electrode may comprise an ohmic layer, a reflective layer, a magnetic layer, a conductive layer, an anti-oxidation layer, an adhesive layer, etc. The ohmic layer may comprise Au, AuBe, etc. The reflective layer may comprise Al, Ag, etc. The magnetic layer may comprise Ni, Co, etc. The conductive layer may comprise Cu, etc. The anti-oxidation layer may comprise Mo, etc. The adhesive layer may comprise Cr, Ti, etc.

The second electrode may comprise a transparent conductive layer. For example, the second electrode may comprise ITO, IZO, etc.

The assembly substrate 200 may comprise a pair of first assembling wirings 201 and second assembling wirings 202 corresponding to each of the semiconductor light-emitting elements 150 to be assembled. Each of the first assembling wiring 201 and the second assembling wiring 202 may be formed by laminating a single metal, a metal alloy, a metal oxide, etc. in multiple layers. For example, each of the first assembling wiring 201 and the second assembling wiring 202 may be formed by comprising at least one of Cu, Ag, Ni, Cr, Ti, Al, Rh, Pd, Ir, Ru, Mg, Zn, Pt, Au, and Hf, but is not limited thereto.

The first assembling wiring 201 and the second assembling wiring 202 form an electric field when an AC voltage is applied, and the semiconductor light-emitting element 150 put into the assembly hole 207H may be fixed by the DEP force caused by the electric field. The gap between the first assembling wiring 201 and the second assembling wiring 202 may be smaller than the width of the semiconductor light-emitting element 150 and the width of the assembly hole 207H, and the assembly position of the semiconductor light-emitting element 150 may be fixed more precisely using the electric field.

An insulation layer 215 is formed on the first assembling wiring 201 and the second assembling wiring 202 to protect the first assembling wiring 201 and the second assembling wiring 202 from the fluid 1200 and prevent leakage of current flowing in the first assembling wiring 201 and the second assembling wiring 202. For example, the insulation layer 215 may be formed as a single layer or multiple layers of an inorganic insulator such as silica or alumina or an organic insulator. The insulation layer 215 may have a minimum thickness to prevent damage to the first assembling wiring 201 and the second assembling wiring 202 during assembly of the semiconductor light-emitting element 150, and may have a maximum thickness to stably assemble the semiconductor light-emitting element 150.

A partition wall 207 may be formed in an upper part of the insulation layer 215. A part of the partition wall 207 may be positioned in the upper parts of the first assembling wiring 201 and the second assembling wiring 202, and the remaining areas may be positioned in an upper part of the assembly substrate 200.

Meanwhile, when manufacturing the assembly substrate 200, a part of the partition wall formed in the upper part of the insulation layer 215 may be removed, thereby forming assembly holes 207H in which each of the semiconductor light-emitting elements 150 is coupled and assembled to the assembly substrate 200.

The assembly substrate 200 has assembly holes 207H formed in which the semiconductor light-emitting elements 150 are coupled, and a surface on which the assembly hole 207H is formed may be in contact with the fluid 1200. The assembly holes 207H may guide the exact assembly positions of the semiconductor light-emitting elements 150, respectively.

Meanwhile, the assembly holes 207H may have a shape and size corresponding to the shape of the semiconductor light-emitting elements 150 to be assembled at the corresponding positions. Accordingly, it is possible to prevent another semiconductor light-emitting element from being assembled in the assembly hole 207H or a plurality of semiconductor light-emitting elements from being assembled.

Referring again to FIG. 6, after the assembly substrate 200 is disposed in the chamber, the assembly device 1100 applying a magnetic field may move along the assembly substrate 200. The assembly device 1100 may be a permanent magnet or an electromagnet.

The assembly device 1100 may move in contact with the assembly substrate 200 to maximize the area affected by the magnetic field within the fluid 1200. Depending on the embodiment, the assembly device 1100 may comprise a plurality of magnetic substances or may comprise a magnetic substance of a size corresponding to the assembly substrate 200. In this instance, the movement distance of the assembly device 1100 may be limited within a predetermined range.

The semiconductor light-emitting element 150 in the chamber 1300 may move toward the assembly device 1100 and the assembly substrate 200 by the magnetic field generated by the assembly device 1100.

The semiconductor light-emitting element 150 may be fixed by entering the assembly hole 207H by the DEP force formed by the electric field between the assembling wirings 201 and 202 while moving toward the assembly device 1100.

Specifically, the first and second assembling wirings 201 and 202 form an electric field by the AC power source, and the DEP force may be formed between the assembling wirings 201 and 202 by this electric field. The semiconductor light-emitting element 150 may be fixed to the assembly hole 207H on the assembly substrate 200 by this DEP force.

At this time, a predetermined solder layer (not illustrated) may be formed between the light-emitting element 150 assembled on the assembly hole 207H of the assembly substrate 200 and the assembling wiring 201 and 202 to improve the bonding strength of the light-emitting element 150.

In addition, a molding layer (not illustrated) may be formed on the assembly hole 207H of the assembly substrate 200 after assembly. The molding layer may be a transparent resin or a resin containing a reflective material or a scattering material.

By the self-assembly method using the electromagnetic field described above, the time required for each semiconductor light-emitting element to be assembled on the substrate may be drastically shortened, so that a large-area, high-pixel display may be implemented more quickly and economically.

Hereinafter, various embodiments for solving the above-described problem will be described with reference to FIGS. 7 to 35B. The omitted descriptions below may be easily understood from the descriptions given above with respect to FIGS. 1 to 6 and the corresponding drawings.

### [Self-assembly method]

FIG. 7 is a drawing illustrating a display device according to an embodiment. FIG. 8 is a cross-sectional view schematically illustrating a display device according to an embodiment.

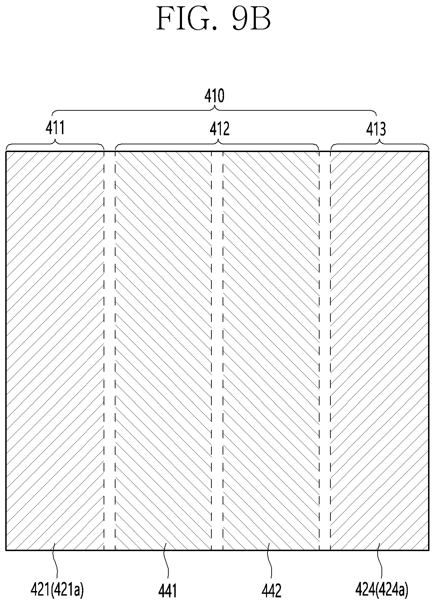

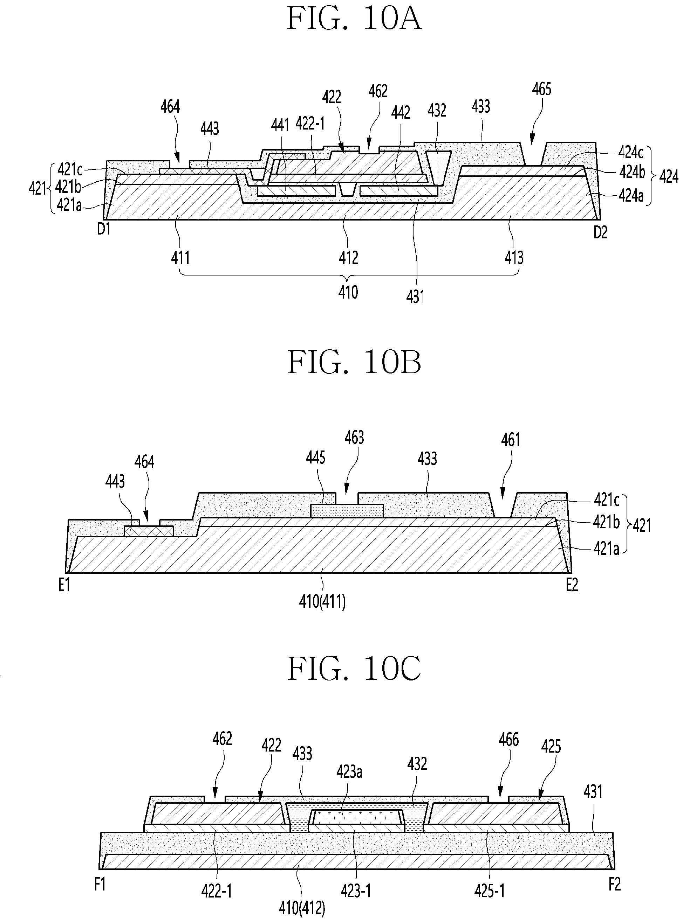

FIG. 9A is a plan view illustrating a semiconductor light-emitting element package according to an embodiment. FIG. 9B is a bottom view illustrating a semiconductor light-emitting element package according to an embodiment. FIG. 10A is a cross-sectional view taken along line D1-D2 in the semiconductor light-emitting element package according to the embodiment of FIG. 9A. FIG. 10B is a cross-sectional view taken along line E1-E2 in the semiconductor light-emitting element package according to the embodiment of FIG. 9A. FIG. 10C is a cross-sectional view taken along line F1-F2 in the semiconductor light-emitting element package according to the embodiment of FIG. 9A.

Referring to FIGS. 7 and 8, a display device 300 according to an embodiment may comprise a display substrate 310, a plurality of semiconductor light-emitting element packages 350, and a first signal line group 361.

The display substrate 310 may serve as a support member for supporting various components of the display device 300.

A plurality of assembly holes 340H may be provided on the display substrate 310. For example, a partition wall 340 may be disposed on the display substrate 310, and a plurality of assembly holes 340H may be formed in the partition wall 340.

A plurality of pixels PX may be defined on the display substrate 310. For example, at least one assembly hole 340H may be provided in one pixel PX. A semiconductor light-emitting element package 350 may be disposed in the assembly hole 340H of the partition wall 340. Accordingly, at least one semiconductor light-emitting element package 350 may be provided in one pixel PX.

The semiconductor light-emitting element package 350 of the embodiment may be assembled into the assembly hole 340H using a self-assembly method. Since the self-assembly method has been described in detail above with reference to FIG. 6, a detailed description thereof will be omitted.

In the embodiment, a plurality of semiconductor light-emitting element packages 350 may be assembled into a plurality of assembly holes 340H using a self-assembly method. To this end, the first assembling wiring 321 and the second assembling wiring 322 may be disposed in the assembly hole 340H of the display substrate 310, and an insulation layer (330, hereinafter referred to as a first insulation layer) may be disposed on the first assembling wiring 321 and the second assembling wiring 322 to insulate the first assembling wiring 321 and the second assembling wiring 322. In this instance, a bottom portion of the assembly hole 340H may be a part of an upper surface of the first insulation layer 330. That is, a part of an upper surface of the first insulation layer 330 may be exposed by the assembly hole 340H.

For example, the shape of the assembly hole 340H may correspond to the shape of the semiconductor light-emitting element package 350. In an embodiment, since the semiconductor light-emitting element package 350 has a square shape when viewed from above, the assembly hole 340H may also have a square shape. For example, the size of the assembly hole 340H may be greater than the size of the semiconductor light-emitting element package 350. That is, when the semiconductor light-emitting element package 350 is inserted into the assembly hole 340H, an outer side surface of the semiconductor light-emitting element package 350 may be spaced apart from an inner side surface of the assembly hole 340H.

According to the embodiment, since the semiconductor light-emitting element package 350 and the assembly hole 340H have a square shape, respectively, when the semiconductor light-emitting element package 350 is assembled into the assembly hole 340H, the semiconductor light-emitting element package 350 may not rotate due to the square shape of the assembly hole 340H and may maintain the current assembled state, thereby strengthening the fixing force of the semiconductor light-emitting element package 350.

After the semiconductor light-emitting element package 350 is assembled into the assembly hole 340H, an insulation layer (360, hereinafter referred to as a second insulation layer) may be formed on the semiconductor light-emitting element package 350 and the partition wall 340. Although not illustrated, a black matrix may be disposed between the pixels PX to distinguish between the pixels PX. The black matrix may be disposed on the partition wall 340, excluding the assembly hole 340H, between the partition wall 340 and the second insulating layer 360, but is not limited thereto.

Meanwhile, the semiconductor light-emitting element package 350 may generate a plurality of different color lights. A color image may be displayed by the plurality of color lights. The plurality of semiconductor light-emitting element packages 350 may be disposed in the plurality of pixels PX, respectively.

The semiconductor light-emitting element package 350 of the embodiment may comprise a first semiconductor light-emitting element 421, a second semiconductor light-emitting element 422, and a third semiconductor light-emitting element 423, as illustrated in FIGS. 9A and 9B. The first semiconductor light-emitting element 421, the second semiconductor light-emitting element 422, and the third semiconductor light-emitting element 423 may emit different color lights to display an image. For example, the first semiconductor light-emitting element 421 may be a blue semiconductor light-emitting element, the second semiconductor light-emitting element 422 may be a green semiconductor light-emitting element, and the third semiconductor light-emitting element 423 may be a red semiconductor light-emitting element, but are not limited thereto.

Meanwhile, the first signal line group 361 may be disposed on one side of each of the plurality of assembly holes 340H and may comprise a plurality of signal lines VDD_1, VDD_2, VDD_3, and VSS. Although not illustrated, a driving transistor (DT of FIG. 3) may be connected between each of the plurality of signal lines VDD_1, VDD_2, VDD_3, and VSS and the pixel PX.

The plurality of signal lines VDD_1, VDD_2, VDD_3, and VSS may be connected to each of the plurality of pixels PX. Each of the plurality of pixels PX may comprise at least one semiconductor light-emitting element package 350. In this instance, a plurality of signal lines VDD_1, VDD_2, VDD_3 and VSS may be connected to a plurality of semiconductor light-emitting elements 421 to 423 of the semiconductor light-emitting element package 350, respectively.

For example, the plurality of signal lines VDD_1, VDD_2, VDD_3 and VSS may comprise a first signal line VDD_1, a second signal line VDD_2, a third signal line VDD_3 and a fourth signal line VSS.

For example, the first signal line VDD_1, the second signal line VDD_2 and the third signal line VDD_3 may be disposed parallel to each other along a second direction Y. For example, the fourth signal line VSS may cross the first signal line VDD_1, the second signal line VDD_2 and the third signal line VDD_3 and may be disposed along a first direction X. In this instance, a pixel PX may be defined by crossings of the first signal line VDD_1, the second signal line VDD_2, the third signal line VDD_3, and the fourth signal line VSS. Accordingly, a pixel PX may be defined for each crossing region of the first signal line VDD_1, the second signal line VDD_2, the third signal line VDD_3, and the fourth signal line VSS.

The first signal line VDD_1, the second signal line VDD_2, the third signal line VDD_3, and the fourth signal line VSS may be connected to a plurality of semiconductor light-emitting elements 421 to 423 of the semiconductor light-emitting element package 350 of each pixel PX through a plurality of connection lines 370-1 to 370-4.

The plurality of connection lines 370-1 to 370-4 may be formed after the semiconductor light-emitting element package 350 is assembled into the assembly hole 340H on the display substrate 310.

For example, the first signal line VDD_1 may be connected to a first side of the first semiconductor light-emitting element 421 via the first connection line 370-1, the second signal line VDD_2 may be connected to a first side of the second semiconductor light-emitting element 422 via the second connection line 370-2, and the third signal line VDD_3 may be connected to a first side of the third semiconductor light-emitting element 423 via the third connection line 370-3.

For example, the fourth signal line VSS may be connected to a second sides of each of the first semiconductor light-emitting element 421, the second semiconductor light-emitting element 422, and the third semiconductor light-emitting element 423 via the fourth connection line 370-4.

Specifically, as illustrated in FIGS. 9A and 9B, the third signal line VDD_3 may be connected to a first electrode pad 445 via the third connection line 370-3. The first electrode pad 445 may be connected to the first side of the third semiconductor light-emitting element 423. For example, the first electrode pad 445 may be horizontally extended from the first side of the third semiconductor light-emitting element 423 onto the first semiconductor light-emitting element 421. In this instance, the third connection line 370-3 may be connected to the first electrode pad 445 positioned on the first semiconductor light-emitting element 421.

The fourth signal line VSS may be connected to a first common pad 443, and the first common pad 443 may be commonly connected to the first semiconductor light-emitting element 421, the second semiconductor light-emitting element 422, and the third semiconductor light-emitting element 423. For example, the first common pad 443 may extend horizontally from the second side of the first semiconductor light-emitting element 421 to the second semiconductor light-emitting element 422 and be connected to the second side of the second semiconductor light-emitting element 422, and may extend horizontally from the second side of the second semiconductor light-emitting element 422 to the third semiconductor light-emitting element 423 and be connected to the second side of the third semiconductor light-emitting element 423.

Meanwhile, since the first electrode pad 445, the first common pad 443, and the connection lines 370-1 to 370-4 are disposed on the upper side of each of the plurality of semiconductor light-emitting elements 421 to 423, the progress of light from each of the plurality of semiconductor light-emitting elements 421 to 423 may be impeded. Accordingly, the first electrode pad 445, the first common pad 443, and the connection lines 370-1 to 370-4 may be made of a conductive material having excellent light transmittance. For example, the first electrode pad 445, the first common pad 443, and the connection lines 370-1 to 370-4 may comprise ITO or IZO, but are not limited thereto.

According to an embodiment, when the first electrode pad 445, the first common pad 443, and the connection lines 370-1 to 370-4 are made of a transparent conductive material, the light emitted from each of the plurality of semiconductor light-emitting elements 421 to 423 does not interfere with the progress of light, so that the light may be easily emitted, thereby preventing a decrease in light efficiency.

Meanwhile, the display device 300 according to the embodiment may comprise a second signal line group 362.

The second signal line group 362 may be disposed on the other side of each of the plurality of assembly holes 340H, and may comprise a plurality of signal lines VDD_1', VDD_2', and VDD_3'. Although not illustrated, a driving transistor (DT of FIG. 3) may be connected between each of the plurality of signal lines VDD_1', VDD_2', and VDD_3' and the pixel PX.

A plurality of signal lines VDD_1', VDD_2', and VDD_3' of the second signal line group 362 may also be connected to the pixel PX. To this end, as illustrated in FIGS. 9A and 9B, the semiconductor light-emitting element package 350 may comprise a fourth semiconductor light-emitting element 424, a fifth semiconductor light-emitting element 425, and a sixth semiconductor light-emitting element 426.

The fourth semiconductor light-emitting element 424, the fifth semiconductor light-emitting element 425, and the sixth semiconductor light-emitting element 426 may emit light of different colors to display an image. For example, the fourth semiconductor light-emitting element 424 may be a blue semiconductor light-emitting element, the fifth semiconductor light-emitting element 425 may be a green semiconductor light-emitting element, and the sixth semiconductor light-emitting element 426 may be a red semiconductor light-emitting element, but are not limited thereto.

For example, the first semiconductor light-emitting element 421, the second semiconductor light-emitting element 422, the fourth semiconductor light-emitting element 424, and the fifth semiconductor light-emitting element 425 may each comprise a GaN-based semiconductor material, and the third semiconductor light-emitting element 423 and the sixth semiconductor light-emitting element 426 may each comprise a GaAs-based semiconductor material, but are not limited thereto.

For example, the fifth signal line VDD_1' may be connected to a first side of the fourth semiconductor light-emitting element 424 via a fifth connection line 371-1, the sixth signal line VDD_2' may be connected to a first side of the fifth semiconductor light-emitting element 425 via a sixth connection line 371-2, and the seventh signal line VDD_3' may be connected to a first side of the sixth semiconductor light-emitting element 426 via a seventh connection line 371-3.

For example, the fourth signal line VSS may be connected to the second sides of each of the fourth semiconductor light-emitting element 424, the fifth semiconductor light-emitting element 425, and the sixth semiconductor light-emitting element 426 via the fourth connection line 370-4.

Specifically, as illustrated in FIG. 7, FIG. 9A, and FIG. 9B, the seventh signal line VDD_3' may be connected to a second electrode pad 446 via the seventh connection line 371-3. The second electrode pad 446 may be connected to the first side of the sixth semiconductor light-emitting element 426. For example, the second electrode pad 446 may be horizontally extended from the first side of the sixth semiconductor light-emitting element 426 to the fourth semiconductor light-emitting element 424. In this instance, the seventh connection line 371-3 may be connected to the second electrode pad 446 positioned on the fourth semiconductor light-emitting element 424.

The fourth signal line VSS may be connected to a second common pad 444, and the second common pad 444 may be commonly connected to the fourth semiconductor light-emitting element 424, the fifth semiconductor light-emitting element 425, and the sixth semiconductor light-emitting element 426. For example, the second common pad 444 may extend horizontally from the second side of the fourth semiconductor light-emitting element 424 to the fifth semiconductor light-emitting element 425 and be connected to the second side of the fifth semiconductor light-emitting element 425, and may extend horizontally from the second side of the fifth semiconductor light-emitting element 425 to the sixth semiconductor light-emitting element 426 and be connected to the second side of the sixth semiconductor light-emitting element 426.

In the embodiment, each of the first to sixth semiconductor light-emitting elements 421 to 426 may be a lateral-type semiconductor light-emitting element that is electrically connectable from an upper side thereof, but is not limited thereto. Both the first side and the second side of each of the first to sixth semiconductor light-emitting elements 421 to 426 may be the upper side or the upper surface. For example, the first side may be the upper surface of each of the second conductivity-type semiconductor layers 421c and 424c, and the second side may be the upper surface of each of the first conductivity-type semiconductor layers 421a and 424a.

Meanwhile, since the second electrode pad 446, the second common pad 444, and the connection lines 371-1 to 371-3 are disposed on the upper side of each of the plurality of semiconductor light-emitting elements 424 to 426, they may impede the progress of light from each of the plurality of semiconductor light-emitting elements 424 to 426. Accordingly, the second electrode pad 446, the second common pad 444, and the connection lines 371-1 to 371-3 may be made of a conductive material having excellent light transmittance. For example, the second electrode pad 446, the second common pad 444, and the connection lines 371-1 to 371-3 may comprise ITO or IZO, but are not limited thereto.

According to an embodiment, when the second electrode pad 446, the second common pad 444, and the connection lines 371-1 to 371-3 are made of a transparent conductive material, the light emitted from each of the plurality of semiconductor light-emitting elements 424 to 426 does not interfere with the progress of light, so that the light may be easily emitted, thereby preventing a decrease in light efficiency.

Meanwhile, the plurality of semiconductor light-emitting elements 421 to 426 included in the semiconductor light-emitting element package 350 of the embodiment may be configured with two pixels or may be configured with one pixel and one dummy pixel.

As illustrated in FIG. 13, in the semiconductor light-emitting element package 350 of the embodiment, the first to third semiconductor light-emitting elements 421 to 423 may configure a first pixel PX1, and the fourth to sixth semiconductor light-emitting elements 421 to 426 may configure a second pixel PX2. When the semiconductor light-emitting element package 350 illustrated in FIG. 13 is disposed in the assembly hole 340H of FIG. 7, the number of pixels is doubled by comprising two pixels PX1 and PX2 per pixel PX, so that an ultra-high-resolution display may be implemented. That is, the blue light, the green light, and the red light may be emitted from the first to third semiconductor light-emitting elements 421 to 423 constituting the first pixel PX1, respectively, by using the blue data signal, the green data signal, and the red data signal applied to the first to third signal lines VDD_1 to VDD_3 included in the first signal line group 361. The blue light, the green light, and the red light may be emitted from the fourth to sixth semiconductor light-emitting elements 424 to 426 constituting the second pixel PX2, respectively, by using the blue data signal, the green data signal, and the red data signal applied to the first to third signal lines VDD_1' to VDD_3' included in the second signal line group 362.

As illustrated in FIG. 14, in the semiconductor light-emitting element package 350 of the embodiment, the first to third semiconductor light-emitting elements 421 to 423 may constitute one pixel PX, and the fourth to sixth semiconductor light-emitting elements 424 to 426 may constitute a dummy pixel PX_D. When the semiconductor light-emitting element package 350 illustrated in FIG. 14 is disposed in the assembly hole 340H illustrated in FIG. 7, the corresponding pixel PX displays an image, and the dummy pixel PX_D does not display an image.

The blue light, the green light and the red light may be emitted from the first to third semiconductor light-emitting elements 421 to 423 constituting the pixel PX1, respectively, by using the blue data signal, the green data signal and the red data signal applied to the first to third signal lines VDD_1 to VDD_3 included in the first signal line group 361. The fourth to sixth semiconductor light-emitting elements 424 to 426 included in the dummy pixel PX_D may not emit light. That is, the blue data signal, the green data signal and the red data signal may be not supplied to the fourth to sixth semiconductor light-emitting elements 424 to 426 included in the dummy pixel PX_D, respectively.

When at least one or more of the first to third semiconductor light-emitting elements 421 to 423 constituting the corresponding pixel PX1 is broken and does not emit light, the broken semiconductor light-emitting element may be replaced with at least one or more of the fourth to sixth semiconductor light-emitting elements 424 to 426 constituting the dummy pixel PX_D. For example, when the second semiconductor light-emitting element 422 constituting the corresponding pixel PX1 is broken, the second semiconductor light-emitting element 422 may be replaced with the fifth semiconductor light-emitting element 425 that emits the same color light as the second semiconductor light-emitting element 422, that is, the green light. To this end, by supplying the green data signal to the fifth signal line VDD_2' instead of the second signal line VDD_2, the green data signal may be not supplied to the second semiconductor light-emitting element 422, but instead may be supplied to the fifth semiconductor light-emitting element 425, so that the fifth semiconductor light-emitting element 425 may emit green light.

Hereinafter, a semiconductor light-emitting element package 350 according to an embodiment will be described with reference to FIGS. 9A, 9B, and 10.

Referring to FIGS. 9A to 10C, a semiconductor light-emitting element package 350 according to an embodiment may comprise a semiconductor substrate 410, a first semiconductor light-emitting element 421, a pair of assembling wirings 441 and 442, a second semiconductor light-emitting element 422, and a third semiconductor light-emitting element 423.

The semiconductor substrate 410 may serve to support the first semiconductor light-emitting element 421, a pair of assembling wirings 441 and 442, the second semiconductor light-emitting element 422, and the third semiconductor light-emitting element 423.

The semiconductor substrate 410 may have a first region 411 and a second region 412. For example, the first region 411 and the second region 412 may be in contact with each other in a horizontal direction.

The first semiconductor light-emitting element 421 may be disposed on the first region 411 of the semiconductor substrate 410, and a pair of assembling wirings 441 and 442 may be disposed on the second region 412 of the semiconductor substrate 410. Accordingly, the pair of assembling wirings 441 and 442 and the first semiconductor light-emitting element 421 may be disposed horizontally with each other. That is, the pair of assembling wirings 441 and 442 and the first semiconductor light-emitting element 421 may not vertically overlap each other.

The first semiconductor light-emitting element 421 may comprise a first conductivity-type semiconductor layer 421a, an active layer 421b, and a second conductivity-type semiconductor layer 421c. For example, the first conductivity-type semiconductor layer 421a may be an n-type semiconductor layer, and the second conductivity-type semiconductor layer 421c may be a p-type semiconductor layer, but are not limited thereto. When voltage is applied to the first semiconductor light-emitting element 421, electrons may be generated in the first conductivity-type semiconductor layer 421a and supplied to the active layer 421b, and holes may be generated in the second conductivity-type semiconductor layer 421c and supplied to the active layer 421b. When the electrons and the holes recombine in the active layer 421b, color light corresponding to a wavelength corresponding to an energy band gap of the semiconductor material of the active layer 421b may be generated. For example, the active layer 421b of the first semiconductor light-emitting element 421 may be formed of a semiconductor material that emits blue light.

Meanwhile, the semiconductor substrate 410 may share the first conductivity-type semiconductor layer 421a of the first semiconductor light-emitting element 421. That is, the first conductivity-type semiconductor layer 421a of the first semiconductor light-emitting element 421 may be used as the semiconductor substrate 410. Accordingly, both the first region 411 and the second region 412 of the semiconductor substrate 410 may be the first conductivity-type semiconductor layer 421a of the first semiconductor light-emitting element 421. In this instance, the active layer 421b and the second conductivity-type semiconductor layer 421c are formed on one side region of the first conductivity-type semiconductor layer 421a, that is, the first region 411 of the semiconductor substrate 410, so that the first semiconductor light-emitting element 421 comprising the first conductivity-type semiconductor layer 421a, the active layer 421b, and the second conductivity-type semiconductor layer 421c may be disposed on the first region 411 of the semiconductor substrate 410. In addition, a pair of assembling wirings 441 and 442 may be disposed on another region of the first conductivity-type semiconductor layer 421a, that is, the second region 412 of the semiconductor substrate 410.

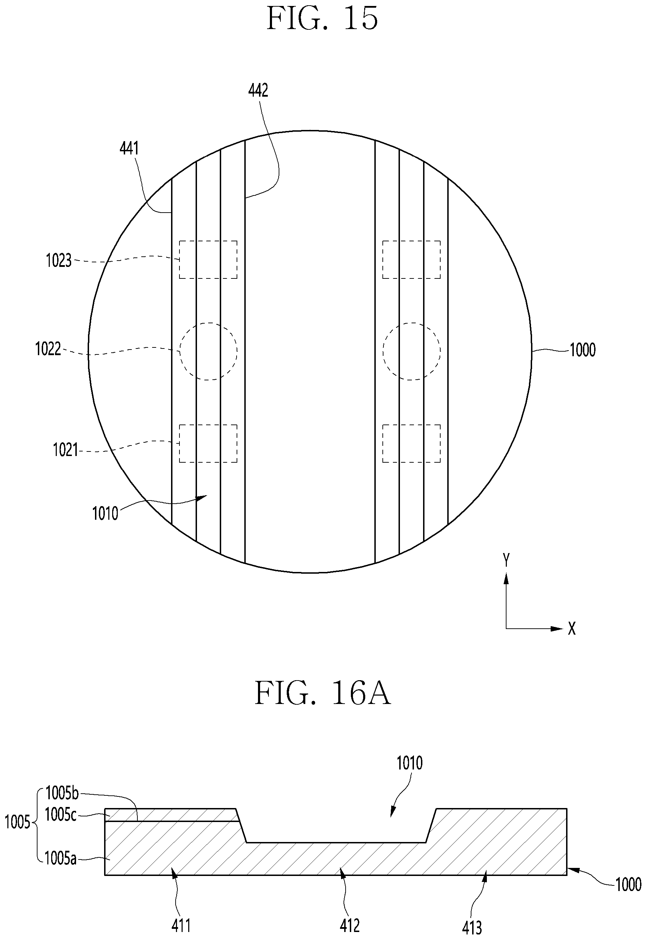

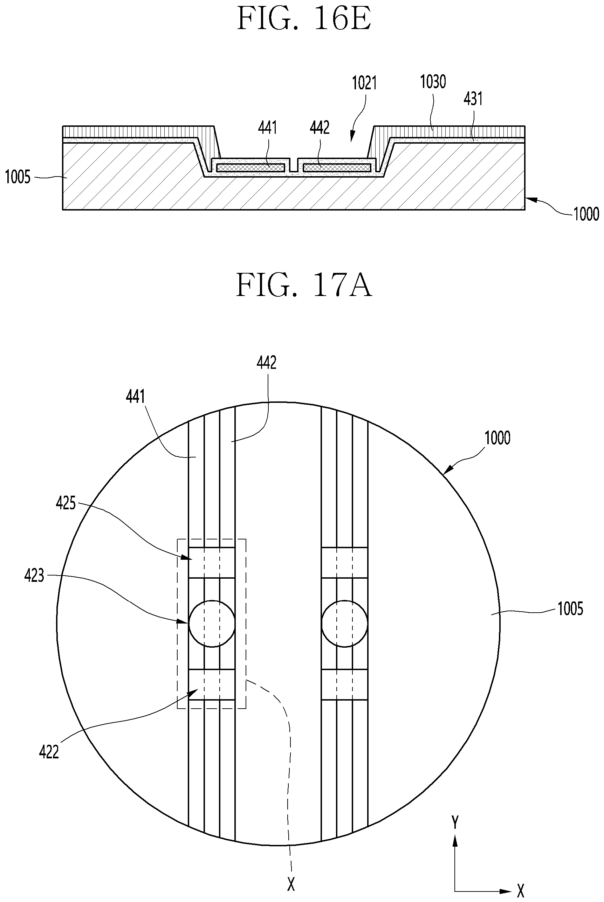

The pair of assembling wirings 441 and 442 may be used to assemble the second semiconductor light-emitting element 422 and the third semiconductor light-emitting element 423 on the second region 412 of the semiconductor substrate 410 by using a self-assembly method. For example, a DEP force may be formed by an AC voltage applied to the pair of assembling wirings 441 and 442, and the second semiconductor light-emitting element 422 and the third semiconductor light-emitting element 423 may be assembled on the pair of assembling wirings 441 and 442 by this DEP force. Although not illustrated in the drawing, a partition wall (1030 of FIG. 16E) comprising assembly holes (1021 to 1023 of FIG. 15) corresponding to each of the second semiconductor light-emitting element 422 and the third semiconductor light-emitting element 423 may be formed so that the second semiconductor light-emitting element 422 and the third semiconductor light-emitting element 423 may be easily assembled. The partition wall 1030 may be removed after the second semiconductor light-emitting element 422 and the third semiconductor light-emitting element 423 are assembled, but is not limited thereto.

Meanwhile, the semiconductor light-emitting element package 350 according to the embodiment may comprise the fourth semiconductor light-emitting element 424, the fifth semiconductor light-emitting element 425, and the sixth semiconductor light-emitting element 426.

The semiconductor substrate 410 may have a third region 413. At this time, the second region 412 may be positioned between the first region 411 and the third region 413. Therefore, the first region 411, the second region 412, and the third region 413 may be sequentially positioned along the horizontal direction.

The fourth semiconductor light-emitting element 424 may be positioned on the third region 413 of the semiconductor substrate 410. The fifth semiconductor light-emitting element 425 and the sixth semiconductor light-emitting element 426 may be positioned on a pair of assembling wirings 441 and 442.

During the self-assembly process, not only the second semiconductor light-emitting element 422 and the third semiconductor light-emitting element 423, but also the fifth semiconductor light-emitting element 425 and the sixth semiconductor light-emitting element 426 may be assembled on the pair of assembling wirings 441 and 442 by the DEP force formed on the pair of assembling wirings 441 and 442.

In the self-assembly process, the second semiconductor light-emitting element 422, the third semiconductor light-emitting element 423, the fifth semiconductor light-emitting element 425, and the sixth semiconductor light-emitting element 426 may be moved by the movement of the magnet. In this instance, to enhance the mobility of each of the second semiconductor light-emitting element 422, the third semiconductor light-emitting element 423, the fifth semiconductor light-emitting element 425, and the sixth semiconductor light-emitting element 426, the second semiconductor light-emitting element 422, the third semiconductor light-emitting element 423, the fifth semiconductor light-emitting element 425, and the sixth semiconductor light-emitting element 426 may comprise magnetic layers 422-1, 423-1, and 425-1, respectively. The magnetic layers 422-1, 423-1, and 425-1 may comprise nickel, cobalt, etc., but are not limited thereto. For example, the magnetic layers 422-1, 423-1, and 425-1 may be provided on a lower side of each of the second semiconductor light-emitting element 422, the third semiconductor light-emitting element 423, the fifth semiconductor light-emitting element 425, and the sixth semiconductor light-emitting element 426, but are not limited thereto.

Although not illustrated in the drawing, a partition wall 1030 comprising assembly holes (1021 to 1023 of FIG. 15) corresponding to the fifth semiconductor light-emitting element 425 and the sixth semiconductor light-emitting element 426, respectively, may be formed so that the fifth semiconductor light-emitting element 425 and the sixth semiconductor light-emitting element 426 may be easily assembled. The partition wall 1030 may be removed after the fifth semiconductor light-emitting element 425 and the sixth semiconductor light-emitting element 426 are assembled, but is not limited thereto.

Meanwhile, the fourth semiconductor light-emitting element 424 may comprise a first conductivity-type semiconductor layer 424a, an active layer 424b, and a second conductivity-type semiconductor layer 424c. The first conductivity-type semiconductor layer 424a may be an n-type semiconductor layer, and the second conductivity-type semiconductor layer 424c may be a p-type semiconductor layer, but are not limited thereto.

The first conductivity-type semiconductor layer 424a of the fourth semiconductor light-emitting element 424 may be connected to the first conductivity-type semiconductor layer 421a of the first semiconductor light-emitting element 421. That is, the first conductivity-type semiconductor layer 424a of the fourth semiconductor light-emitting element 424 and the first conductivity-type semiconductor layer 421a of the first semiconductor light-emitting element 421 may be formed integrally. Accordingly, the first conductivity-type semiconductor layer 421a of the first semiconductor light-emitting element 421 or the first conductivity-type semiconductor layer 424a of the fourth semiconductor light-emitting element 424 may be used as the first region 411, the second region 412, and the third region 413 of the semiconductor substrate 410.

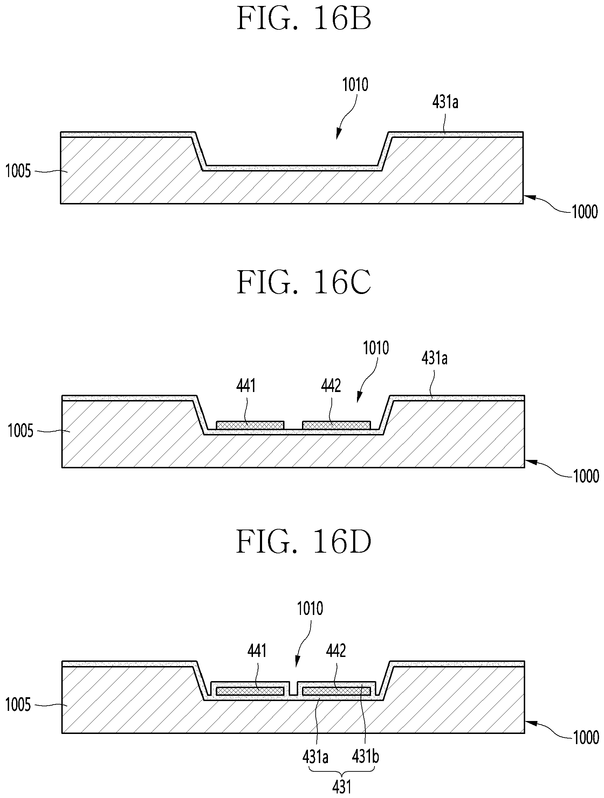

For example, the active layer 421b and the second conductivity-type semiconductor layer 421c of the first semiconductor light-emitting element 421 or the active layer 424b and the second conductivity-type semiconductor layer 424c of the fourth semiconductor light-emitting element 424 may be not disposed on the second region 412 of the semiconductor substrate 410. Accordingly, a recess (1010 of FIG. 16C or FIG. 16D) may be formed on the second region 412 of the semiconductor substrate 410.

For example, a second semiconductor light-emitting element 422, a third semiconductor light-emitting element 423, a fifth semiconductor light-emitting element 425, and a sixth semiconductor light-emitting element 426 may be disposed between the first semiconductor light-emitting element 421 and the fourth semiconductor light-emitting element 424. For example, a third semiconductor light-emitting element 423 and a sixth semiconductor light-emitting element 426 may be disposed between the second semiconductor light-emitting element 422 and the fifth semiconductor light-emitting element 425.

The first semiconductor light-emitting element 421 and the fourth semiconductor light-emitting element 424 may be symmetrical to each other with respect to the center of the semiconductor light-emitting element package 350. The second semiconductor light-emitting element 422 and the fifth semiconductor light-emitting element 425 may be symmetrical to each other with respect to the center of the semiconductor light-emitting element package 350. The third semiconductor light-emitting element 423 and the sixth semiconductor light-emitting element 426 may be symmetrical to each other with respect to the center of the semiconductor light-emitting element package 350.

The second semiconductor light-emitting element 422, the third semiconductor light-emitting element 423, the fifth semiconductor light-emitting element 425, and the sixth semiconductor light-emitting element 426 may be disposed on a pair of assembling wirings 441 and 442. For example, the second semiconductor light-emitting element 422, the third semiconductor light-emitting element 423, the fifth semiconductor light-emitting element 425, and the sixth semiconductor light-emitting element 426 may be simultaneously self-assembled on a pair of assembling wirings 441 and 442 by a DEP force formed on a pair of assembling wirings 441 and 442.

For example, the third semiconductor light-emitting element 423 and the sixth semiconductor light-emitting element 426 may be disposed between the second semiconductor light-emitting element 422 and the fifth semiconductor light-emitting element 425. Accordingly, the second semiconductor light-emitting element 422, the third semiconductor light-emitting element 423, the sixth semiconductor light-emitting element 426, and the fifth semiconductor light-emitting element 425 may be disposed in the order of the lengthwise direction of the pair of assembling wirings 441 and 442, that is, the Y direction.

The third semiconductor light-emitting element 423 and the sixth semiconductor light-emitting element 426 may be symmetrical to each other with respect to the lengthwise direction of the pair of assembling wirings 441 and 442. For example, the third semiconductor light-emitting element 423 and the sixth semiconductor light-emitting element 426 may have a circular shape when viewed from above. That is, since each of the third semiconductor light-emitting element 423 and the sixth semiconductor light-emitting element 426 has a hemispherical shape, the third semiconductor light-emitting element 423 and the sixth semiconductor light-emitting element 426 having such a hemispherical shape may be disposed to be symmetrical to each other, so that the third semiconductor light-emitting element 423 and the sixth semiconductor light-emitting element 426 may have a circular shape when viewed from above. For example, the third semiconductor light-emitting element 423 may be disposed on a first assembling wiring 441 of the pair of assembling wirings 441 and 442, and the sixth semiconductor light-emitting element 426 may be disposed on a second assembling wiring 442 of the pair of assembling wirings 441 and 442.

Meanwhile, unexplained reference numerals 461 to 466 may be contact holes. Through these contact holes 461 to 466, a plurality of connection lines 370-1 to 370-4 and 371-1 to 371-3 may be connected to a plurality of semiconductor light-emitting elements 421 to 426 of the semiconductor light-emitting element package 350.

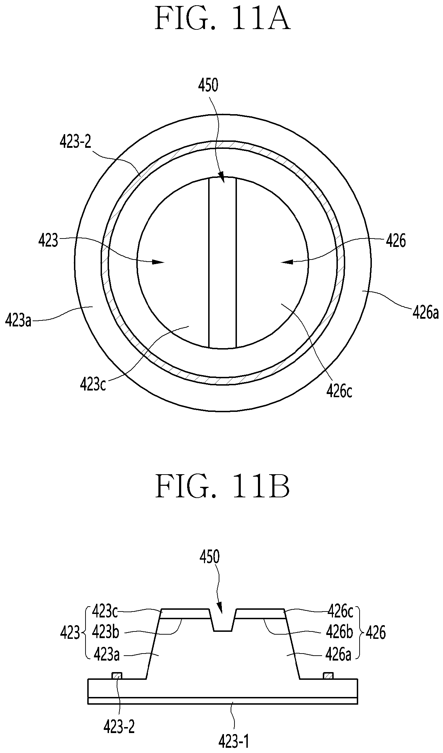

Meanwhile, as illustrated in FIGS. 11A and 11B, a part of the third semiconductor light-emitting element 423 and a part of the sixth semiconductor light-emitting element 426 may be connected to each other, and a recess 450 may be formed between the third semiconductor light-emitting element 423 and the sixth semiconductor light-emitting element 426.

The third semiconductor light-emitting element 423 may comprise a first conductivity-type semiconductor layer 423a, an active layer 423b, and a second conductivity-type semiconductor layer 423c. The sixth semiconductor light-emitting element 426 may comprise a first conductivity-type semiconductor layer 426a, an active layer 426b, and a second conductivity-type semiconductor layer 426c.

For example, the first conductivity-type semiconductor layer 423a of the third semiconductor light-emitting element 423 and the first conductivity-type semiconductor layer 426a of the sixth semiconductor light-emitting element 426 may be connected. As illustrated in FIG. 13, when driven by two pixels PX1 and PX2, even if the second common pad 444 is not connected to the first conductivity-type semiconductor layer 426a of the sixth semiconductor light-emitting element 426, the first common pad 443 may be connected to the first conductivity-type semiconductor layer 423a of the third semiconductor light-emitting element 423. Accordingly, by supplying different red data signals to the first electrode pad 445 and the second electrode pad 446, different luminance (or gradations) may be obtained from the third semiconductor light-emitting element 423 of the first pixel PX1 and the sixth semiconductor light-emitting element 426 of the second pixel PX2, respectively, thereby enabling implementation of ultra-high resolution.

Although not illustrated, the first conductivity-type semiconductor layer 423a of the third semiconductor light-emitting element 423 and the first conductivity-type semiconductor layer 426a of the sixth semiconductor light-emitting element 426 may not be connected but may be spatially separated from each other and insulated with an insulating material therebetween.

The unexplained symbol 423-2 is an electrode, and may comprise a metal having excellent ohmic contact characteristics. A first electrode pad 445 or a second electrode pad 446 may be connected to the electrode 423-2.

Meanwhile, the semiconductor light-emitting element package 350 according to the embodiment may comprise a first electrode pad 445, a second electrode pad 446, a first common pad 443, and a second common pad 444. Since the first electrode pad 445, the second electrode pad 446, the first common pad 443, and the second common pad 444 are disposed on the first to sixth semiconductor light-emitting elements 421 to 426, they may be made of a transparent conductive material not to interfere with the forward progress of the corresponding lights.

For example, the first electrode pad 445 may extend horizontally in a direction of a second upper side of the first semiconductor light-emitting element 421 on the second upper side of the third semiconductor light-emitting element 423, and the second electrode pad 446 may extend horizontally in a direction of a second upper side of the fourth semiconductor light-emitting element 424 on the second upper side of the sixth semiconductor light-emitting element 426.

For example, the first common pad 443 may be commonly connected to a first upper side of each of the first semiconductor light-emitting element 421, the second semiconductor light-emitting element 422, and the third semiconductor light-emitting element 423, and the second common pad 444 may be commonly connected to a first upper side of each of the fourth semiconductor light-emitting element 424, the fifth semiconductor light-emitting element 425, and the sixth semiconductor light-emitting element 426.

Currents of each of the first semiconductor light-emitting element 421, the second semiconductor light-emitting element 422, and the third semiconductor light-emitting element 423 may flow to the fourth signal line VSS through the first common pad 443. Currents of each of the fourth semiconductor light-emitting element 424, the fifth semiconductor light-emitting element 425, and the sixth semiconductor light-emitting element 426 may flow to the fourth signal line VSS through the second common pad 444.

The first common pad 443 may extend from the third semiconductor light-emitting element 423 to the first semiconductor light-emitting element 421 via the second semiconductor light-emitting element 422. The second common pad 444 may extend from the sixth semiconductor light-emitting element 426 to the fourth semiconductor light-emitting element 424 via the fifth semiconductor light-emitting element 425.

The first common pad 443 and the second common pad 444 may be positioned diagonally with respect to the center of the semiconductor light-emitting element package 350. Each of the first common pad 443 and the second common pad 444 may have a bent portion 443a and 444a bent at a predetermined position. For example, the bent portions 443a and 444a of the first common pad 443 and the second common pad 444 may be positioned on the second side of the second semiconductor light-emitting element 422 or the second side of the fifth semiconductor light-emitting element 425, but are not limited thereto.

Meanwhile, the semiconductor light-emitting element package 350 according to the embodiment may comprise a first insulation layer 431, a second insulation layer 432, and a third insulation layer 433.

The first insulation layer 431 may be formed between the second region 412 of the semiconductor substrate 410 and the pair of assembling wirings 441 and 442. The first insulation layer 431 may prevent an electrical short between the semiconductor substrate 410 and the pair of assembling wirings 441 and 442.

The second insulation layer 432 may be formed around each of the second semiconductor light-emitting element 422, the third semiconductor light-emitting element 423, the fifth semiconductor light-emitting element 425, and the sixth semiconductor light-emitting element 426. The second insulation layer 432 may firmly fix each of the second semiconductor light-emitting element, the third semiconductor light-emitting element 423, the fifth semiconductor light-emitting element 425, and the sixth semiconductor light-emitting element 426 to the semiconductor substrate 410.

The third insulation layer 433 may be formed on the first to sixth semiconductor light-emitting elements 421 to 426. The third insulation layer 433 may protect the first to sixth semiconductor light-emitting elements 421 to 426 from an electrical short caused by an external impact or an external foreign substance.

The first insulation layer 431, the second insulation layer 432, and the third insulation layer 433 may be formed of different insulating materials. For example, the first insulation layer 431 and the third insulation layer 433 may be formed of an inorganic material, and the second insulation layer 432 may be formed of an organic material, but are not limited thereto. For example, the first insulation layer 431 and the third insulation layer 433 may be formed of the same insulating material, but are not limited thereto.

Meanwhile, in the semiconductor light-emitting element package 350 according to the embodiment, a plurality of semiconductor light-emitting elements 422, 423, 425, and 426 may be assembled into the assembly hole 340H illustrated in FIGS. 7 and 8 using a self-assembly process. Since the semiconductor light-emitting element package 350 according to the embodiment is provided with a plurality of semiconductor light-emitting elements 421 to 426, it may not be easy for the semiconductor light-emitting element package 350 to be moved by a magnet during the self-assembly process. Therefore, to enhance the mobility of the semiconductor light-emitting element package 350, a pair of assembling wirings 441 and 442 of the semiconductor light-emitting element package 350 may comprise at least two or more metal layers comprising at least a magnetic layer. The larger the area of the magnetic layer, the greater the magnetization characteristic. To this end, the overall width W1 of the pair of assembling wirings 441 and 442 may be greater than the width W2 of the first semiconductor light-emitting element 421 or the fourth semiconductor light-emitting element 424.

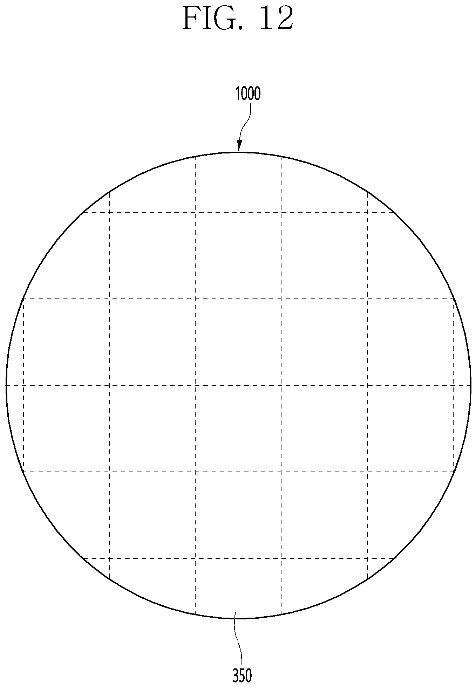

Meanwhile, the semiconductor light-emitting element package 350 according to the embodiment may be manufactured on the wafer 1000 illustrated in FIG. 12. That is, an epitaxial layer (1005 of FIG. 16A) for forming a first semiconductor light-emitting element 421 or a fourth semiconductor light-emitting element 424 may be formed on a wafer 1000, an upper side of the epitaxial layer 1005 may be etched to form a recess 1010, a pair of assembling wirings 441 and 442 may be formed in the recess 1010, and a second semiconductor light-emitting element 422, a third semiconductor light-emitting element 423, a fifth semiconductor light-emitting element 425, and a sixth semiconductor light-emitting element 426 may be assembled using a self-assembly process, and then, through a series of post-processes, a plurality of semiconductor light-emitting element packages 350 each comprising the first semiconductor light-emitting element 421 and the fourth semiconductor light-emitting element 424 formed in the epitaxial layer 1005, as well as the second semiconductor light-emitting element 422, the third semiconductor light-emitting element 423, the fifth semiconductor light-emitting element 425, and the sixth semiconductor light-emitting element 426, may be manufactured. Thereafter, a plurality of semiconductor light-emitting element packages 350 may be separated from the wafer 1000 through a separation process.

### [Manufacturing process of semiconductor light-emitting element package]

FIGS. 15 to 34 illustrate a manufacturing process of a semiconductor light-emitting element package according to an embodiment.

Referring to FIG. 15, first, a plurality of assembly holes 1021 to 1023 may be formed along a second direction Y on the wafer 1000.

Specifically, as illustrated in FIG. 16A, an epitaxial layer 1005 may be formed on the wafer 1000. The epitaxial layer 1005 may comprise a plurality of semiconductor layers 1005a, 1005b, and 1005c. The plurality of semiconductor layers may comprise a first semiconductor layer 1005a, a second semiconductor layer 1005b, and a third semiconductor layer 1005c. The first semiconductor layer 1005a, the second semiconductor layer 1005b, and the third semiconductor layer 1005c may each comprise a plurality of layers.

For example, the wafer 1000 may support the epitaxial layer 1005, and may also be a member that facilitates a deposition of the epitaxial layer 1005, and may be, for example, a sapphire substrate, a semiconductor substrate, or a ceramic substrate.

For example, the first semiconductor layer 1005a may be a first conductivity-type semiconductor layer and may comprise a first conductive dopant. For example, the second semiconductor layer 1005b may be an active layer and may generate light. Light having a wavelength corresponding to a bandgap of a semiconductor material of the active layer 1005b may be generated. For example, the third semiconductor layer 1005c may be a second conductivity-type semiconductor layer and may comprise a second conductive dopant. The first conductive dopant may be an n-type dopant, and the second conductive dopant may be a p-type dopant, but are not limited thereto.

The first semiconductor layer 1005a, the second semiconductor layer 1005b, and the third semiconductor layer 1005c may be sequentially deposited on the wafer 1000 using a deposition equipment, such as an MOCVD deposition equipment.

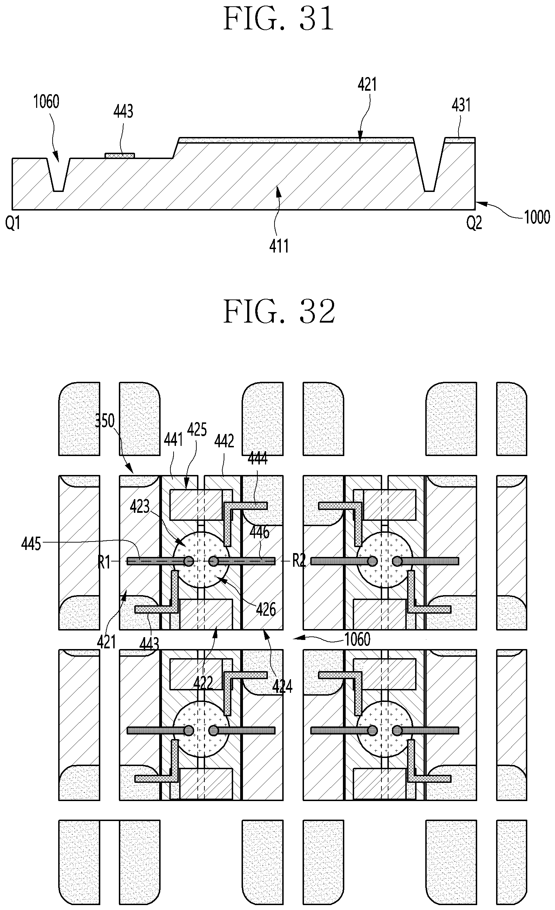

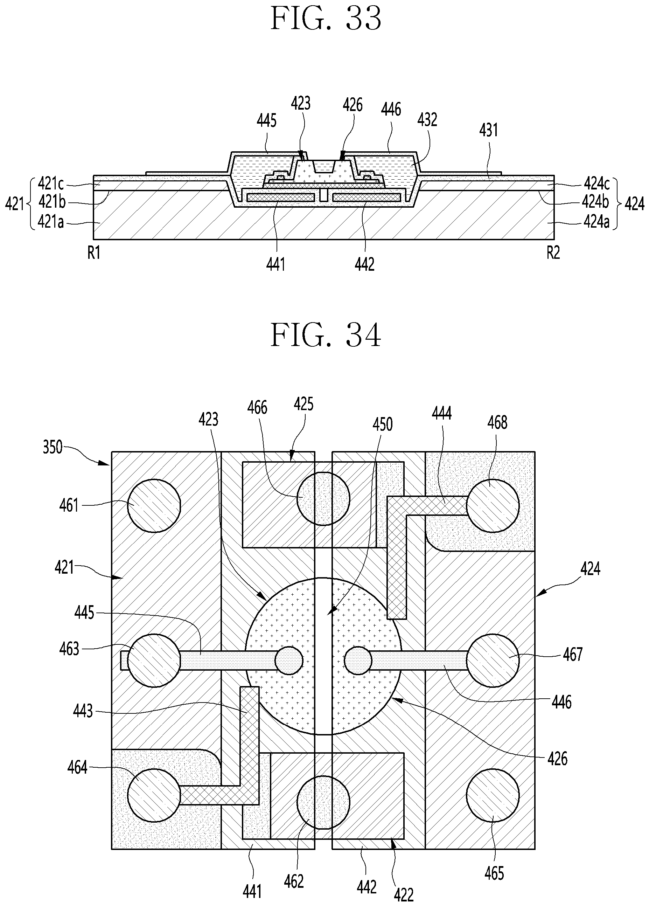

As will be described later, the first semiconductor light-emitting element (421 of FIG. 32) may be formed by using a first region 411 of the epitaxial layer 1005, and the fourth semiconductor light-emitting element 424 may be formed by using a second region 412 of the epitaxial layer 1005. Accordingly, the first semiconductor light-emitting element 421 and the fourth semiconductor light-emitting element 424 may comprise active layers (421b, 424b in FIG. 33) made of the same semiconductor material, so that they may generate the same color light.

Meanwhile, a recess 1010 may be formed by etching an upper surface of the epitaxial layer 1005 inwardly along the Y direction. That is, the third semiconductor layer 1005c and the second semiconductor layer 1005b of the epitaxial layer 1005 may be removed, and a part of an upper surface of the first semiconductor layer 1005a may be removed, thereby forming the recess 1010. Accordingly, the depth of the recess 1010 may be the sum of the thickness of the third semiconductor layer 1005c, the thickness of the second semiconductor layer 1005b, and the thickness of a part of the upper surface of the first semiconductor layer 1005a removed

Even if the recess 1010 is formed, the epitaxial layers 1005 may be connected to each other through the recess 1010. That is, since the bottom portion of the recess 1010 is the first semiconductor layer 1005a of the epitaxial layer 1005, the first semiconductor layers 1005a of the epitaxial layer 1005 on both sides of the recess 1010 may be connected to each other. The first semiconductor layer 1005a of the epitaxial layer 1005 on the left side of the recess 1010 may be defined as the first region 411, the first semiconductor layer 1005a of the epitaxial layer 1005 below the recess 1010 may be defined as the second region 412, and the first semiconductor layer 1005a of the epitaxial layer 1005 on the right side of the recess 1010 may be defined as the third region 413.

As illustrated in FIG. 16B, an insulation layer 431a may be formed on the epitaxial layer 1005. Since the epitaxial layer 1005 comprises a dopant, the insulation layer 431a may be formed to insulate the epitaxial layer 1005.

As illustrated in FIG. 16C, a pair of assembling wirings 441 and 442 may be formed in the recess 1010. For example, a metal film may be deposited on the insulation layer 431a and then patterned, thereby forming a pair of assembling wirings 441 and 442 in the recess 1010. The pair of assembling wirings 441 and 442 may be formed to be long along the second direction Y. The pair of assembling wirings 441 and 442 may be made of a metal having excellent electrical conductivity. The pair of assembling wirings 441 and 442 may each comprise a magnetic layer that may be easily magnetized by a magnet.

As illustrated in FIG. 16D, the other insulation layer 431b may be formed on the pair of assembling wirings 441 and 442 and the insulation layer 431a. The insulation layer 431a and the other insulation layer 431b may be formed of the same insulating material. Accordingly, a first insulation layer 431 may be formed by the insulation layer 431a and the other insulation layer 431b. Accordingly, an electrical short between a pair of assembling wirings 441 and 442 and the epitaxial layer 1005 may be prevented by the first insulation layer 431, and the epitaxial layer 1005 may be protected from external foreign substances.

As illustrated in FIG. 16E, a partition wall 1030 may be formed on the first insulation layer 431. Since the partition wall 1030 is formed with a relatively thick thickness, it may be formed of an organic material, but is not limited thereto.

As illustrated in FIG. 15, the partition wall 1030 may comprise a plurality of assembly holes 1021 to 1023. The plurality of assembly holes 1021 to 1023 may be positioned on a pair of assembling wirings 441 and 442 within the recess 1010.

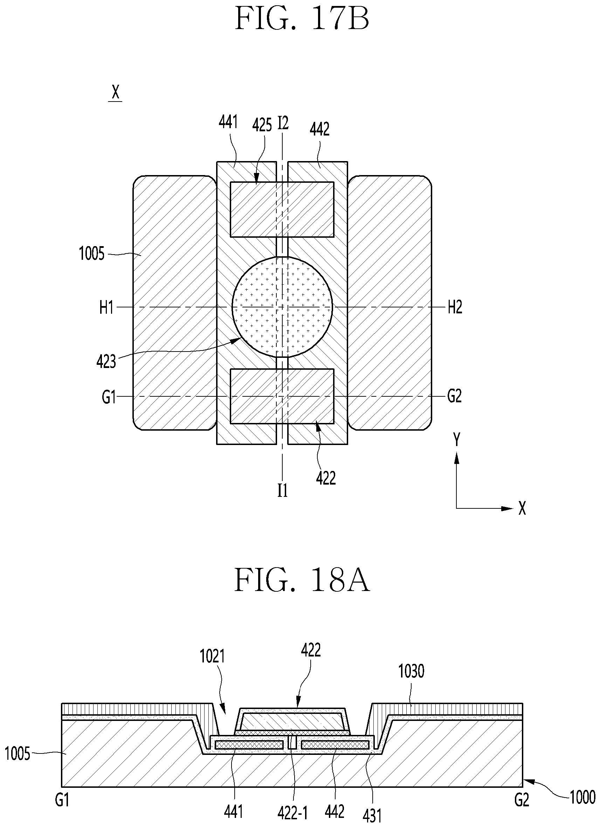

Meanwhile, referring to FIGS. 17A and 17B, a plurality of semiconductor light-emitting elements 422, 423, and 425 may be assembled on a pair of assembling wirings 441 and 442 using self-assembly.

Specifically, after the wafer 1000 is mounted in a chamber filled with a fluid (not illustrated) for self-assembly, a DEP force may be formed by an AC voltage applied to the pair of assembling wirings 441 and 442. As the magnet moves, the plurality of semiconductor light-emitting elements 422, 423, and 425 within the fluid may move. The plurality of semiconductor light-emitting elements 422, 423, and 425 may be moved in a fluid and then assembled into a plurality of assembly holes 1021 to 1023 on a wafer 1000. That is, since the DEP force formed by the pair of assembly wires 441 and 442 is formed in each of the plurality of assembly holes 1021 to 1023, the plurality of moving semiconductor light-emitting elements 422, 423, and 425 may be assembled in each of the plurality of assembly holes 1021 to 1023 by the DEP force.

For simultaneous assembly, the plurality of semiconductor light-emitting elements 422, 423, and 425 may have different shapes from each other.

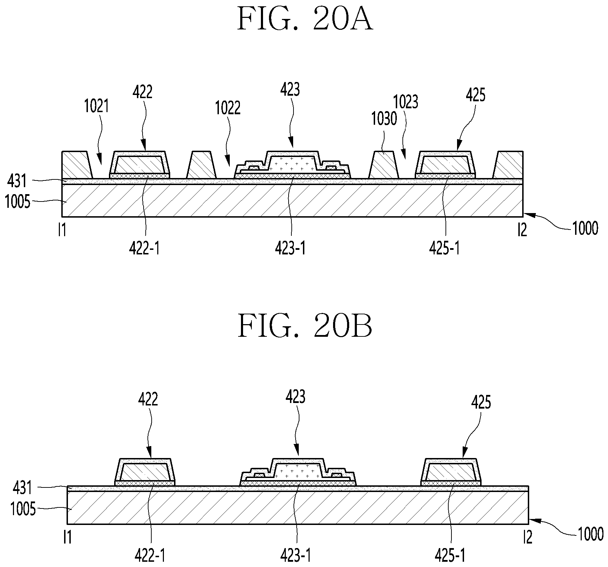

Each of the plurality of semiconductor light-emitting elements 422, 423 and 425 may be a pre- manufactured component. That is, each of the plurality of semiconductor light-emitting elements 422, 423 and 425 may be manufactured using a series of semiconductor processes. Each of the plurality of semiconductor light-emitting elements 422, 423, and 425, respectively, may comprise a first conductivity-type semiconductor layer (not illustrated), an active layer (not illustrated), a second conductivity-type semiconductor layer (not illustrated), and a magnetic layer (422-1, 423-1, 425-1 of FIG. 20A). For example, the third semiconductor light-emitting element 423 comprises a first electrode 423-2 on an upper surface of the first conductivity-type semiconductor layer, but is not limited thereto. A common pad (443, 444 of FIG. 9A) may be connected to the first electrode 423-2.

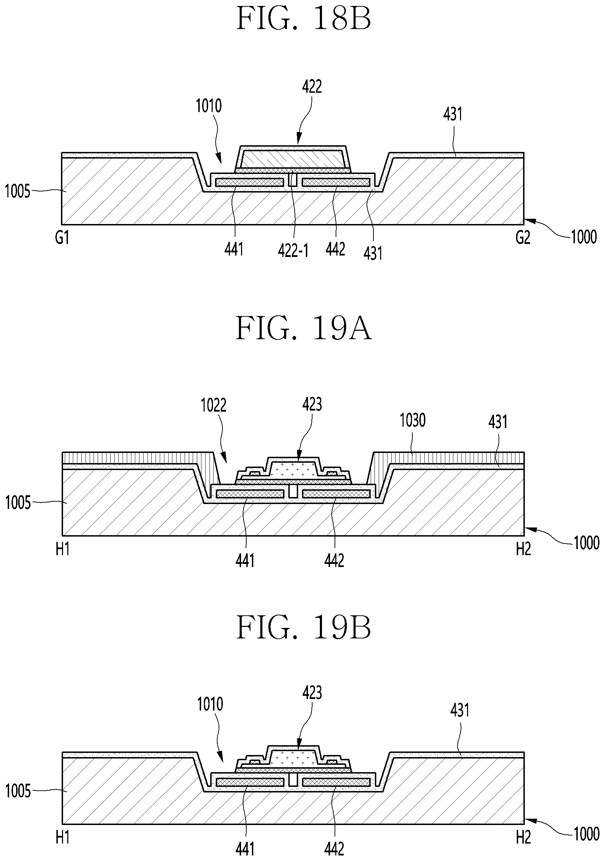

First, as illustrated in FIG. 18A, FIG. 19A, and FIG. 20A, a plurality of semiconductor light-emitting elements 422, 423, and 425 may be assembled into a plurality of assembly holes 1021 to 1023, respectively, by the DEP force formed on a pair of assembling wirings 441 and 442.

Thereafter, by spraying a polymer and then removing it, the plurality of semiconductor light-emitting elements 422, 423, and 425 may be attached to the first insulation layer 431 by the polymer. When the polymer is removed, the partition wall 1030 may also be removed, but is not limited thereto.

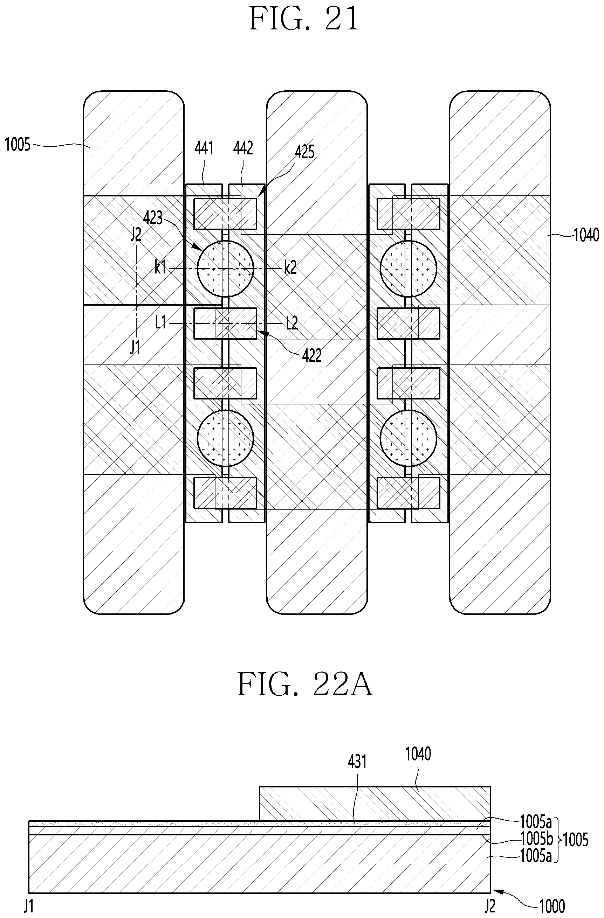

Meanwhile, referring to FIG. 21, by partially patterning using the mask 1040, the third semiconductor light-emitting element 423 and the sixth semiconductor light-emitting element 426 may be formed from the third semiconductor light-emitting element 423, and the first semiconductor layer 1005a, i.e., the first conductivity-type semiconductor layer, may be exposed in the epitaxial layer 1005, and also the first conductivity-type semiconductor layer may be exposed in each of the second semiconductor light-emitting element 422 and the fifth semiconductor light-emitting element 425.

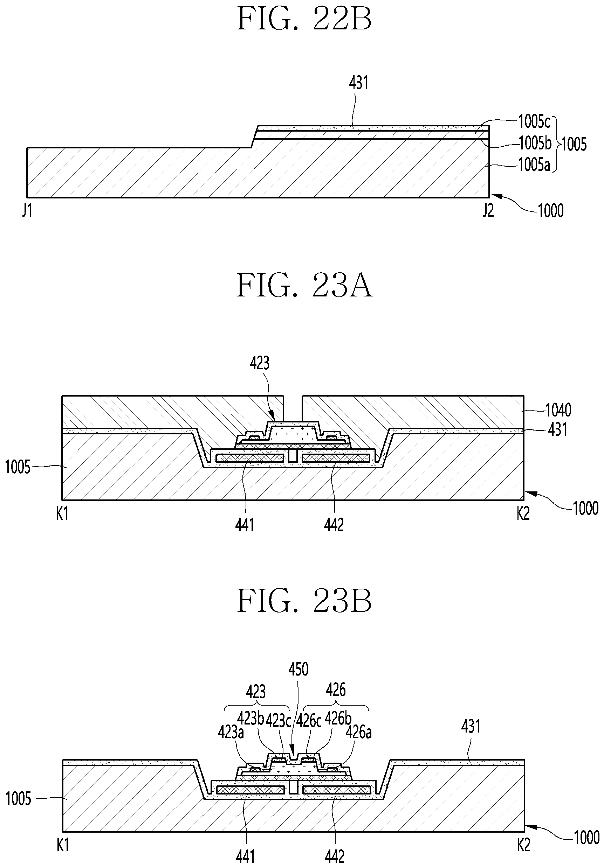

Specifically, as illustrated in FIG. 22A, after a part of the epitaxial layer 1005 is blocked by the mask 1040, as illustrated in FIG. 22B, the third semiconductor layer 1005c and the second semiconductor layer 1005b of the epitaxial layer 1005, which are not blocked by the mask 1040, may be removed, so that the first semiconductor layer 1005a may be exposed. A part of the upper surface of the first semiconductor layer 1005a may also be removed, but is not limited thereto. Thereafter, the mask 1040 may be removed.

As illustrated in FIG. 23A, after the remaining region except the center region of the third semiconductor layer 1005c is blocked by the mask 1040, as illustrated in FIG. 23B, the second conductivity-type semiconductor layer 423c and the active layer 423b positioned at the center region of the third semiconductor light-emitting element 423, which is not blocked by the mask 1040, may be removed to form a recess 450, so that the first conductivity-type semiconductor layer may be exposed. A part of the upper surface of the first conductivity-type semiconductor layer may also be removed, but is not limited thereto. Thereafter, the mask 1040 may be removed.

The third semiconductor light-emitting element 423 may be separated into the third semiconductor light-emitting element 423 and the sixth semiconductor light-emitting element 426 with respect to the center line of the third semiconductor light-emitting element 423. Even though the third semiconductor light-emitting element 423 and the sixth semiconductor light-emitting element 426 are separated, the third semiconductor light-emitting element 423 and the sixth semiconductor light-emitting element 426 may be connected. That is, the third semiconductor light-emitting element 423 and the sixth semiconductor light-emitting element 426 may be connected by the first conductivity-type semiconductor layer.

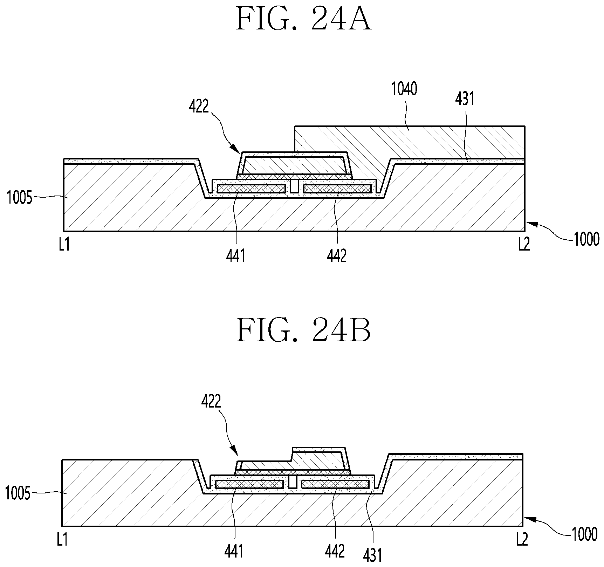

As illustrated in FIG. 24A, after a part of the second semiconductor light-emitting element 422 is blocked by the mask 1040, as illustrated in FIG. 24B, the second conductivity-type semiconductor layer and the active layer of the second semiconductor light-emitting element 422 that are not blocked by the mask 1040 may be removed, so that the first conductivity-type semiconductor layer may be exposed. A part of the upper surface of the first conductivity-type semiconductor layer may also be removed, but is not limited thereto. Thereafter, the mask 1040 may be removed.

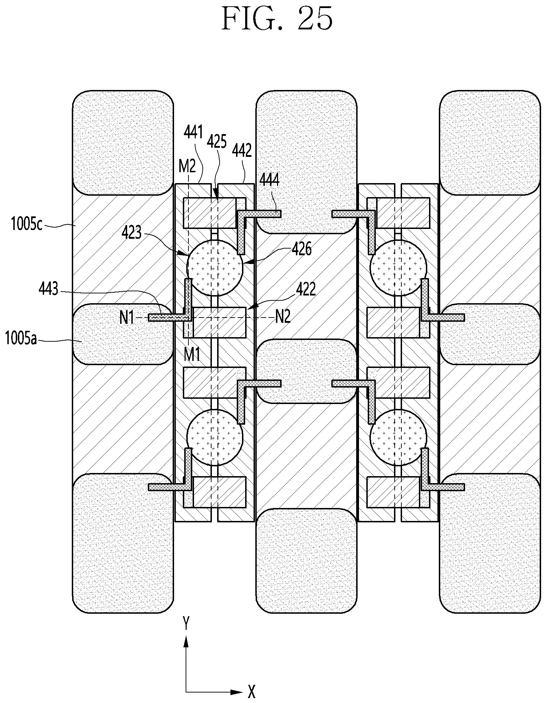

Meanwhile, referring to FIG. 25, a first common pad 443 and a second common pad 444 may be formed.

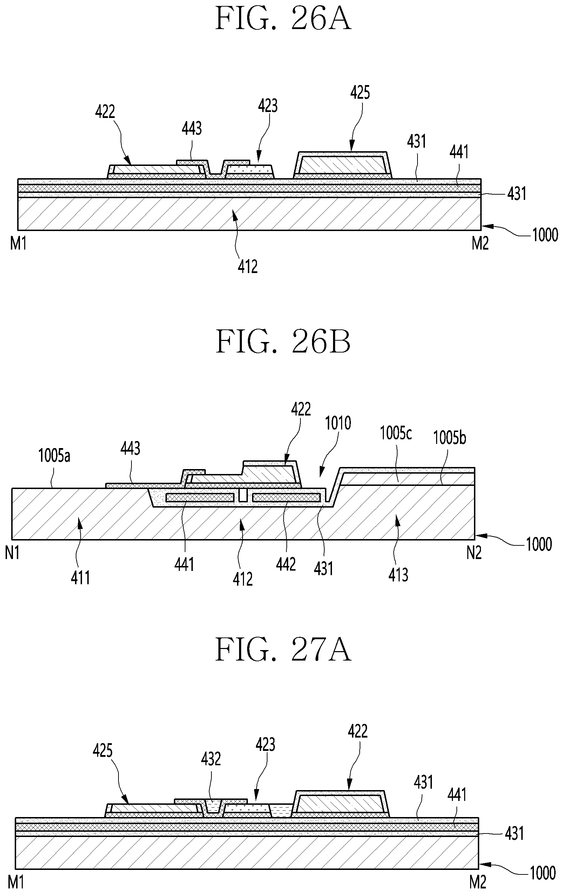

Specifically, as illustrated in FIGS. 26A and 26B, a metal film may be deposited on the wafer 1000 and then patterned to form a first common pad 443 and a second common pad 444.

For example, a first semiconductor layer 1005a of a first region 411 of an epitaxial layer 1005, a first conductivity-type semiconductor layer of a second semiconductor light-emitting element 422, and a first conductivity-type semiconductor layer 423a of a third semiconductor light-emitting element 423 may be connected by the first common pad 443.

For example, the first semiconductor layer 1005a of the third region 413 of the epitaxial layer 1005, the first conductivity-type semiconductor layer of the fifth semiconductor light-emitting element 425, and the first conductivity-type semiconductor layer 426a of the sixth semiconductor light-emitting element 426 may be connected by the second common pad 444.

Although not illustrated, the first common pad 443 and the second common pad 444 may be connected to a pair of assembling wirings 441 and 442, but are not limited thereto.

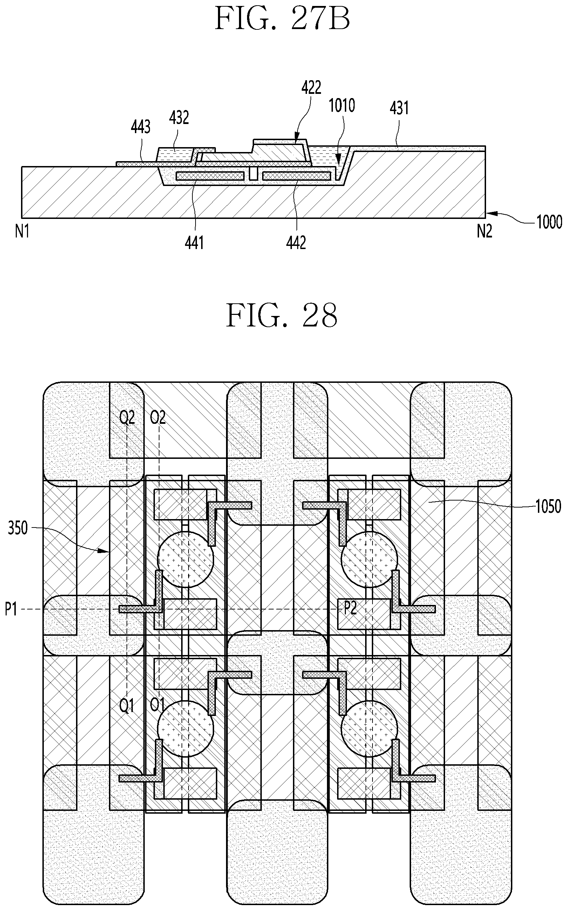

Thereafter, as illustrated in FIGS. 27A and 27B, the second insulation layer 432 may be formed within the recess 1010.

For example, the second insulation layer 432 may be formed along the perimeter of each of the second semiconductor light-emitting element 422, the third semiconductor light-emitting element 423, the fifth semiconductor light-emitting element 425, and the sixth semiconductor light-emitting element 426, which are disposed on a pair of assembling wirings 441 and 442. Each of the second semiconductor light-emitting element 422, the third semiconductor light-emitting element 423, the fifth semiconductor light-emitting element 425, and the sixth semiconductor light-emitting element 426 may be firmly fixed to the first insulation layer 431 by the second insulation layer 432.

When each of the second semiconductor light-emitting element 422, the third semiconductor light-emitting element 423, the fifth semiconductor light-emitting element 425, and the sixth semiconductor light-emitting element 426 is firmly fixed to the first insulation layer 431, the second insulation layer 432 may be omitted.

Meanwhile, referring to FIG. 28, the epitaxial layer 1005 may be patterned using the mask 1050, so that a plurality of semiconductor light-emitting element packages 350 may be formed on the wafer 1000. For example, all layers of the epitaxial layer 1005, i.e., the first semiconductor layer 1005a, the second semiconductor layer 1005b, and the third semiconductor layer 1005c, may be removed, so that the upper surface of the wafer 1000, e.g., the sapphire substrate, may be exposed.

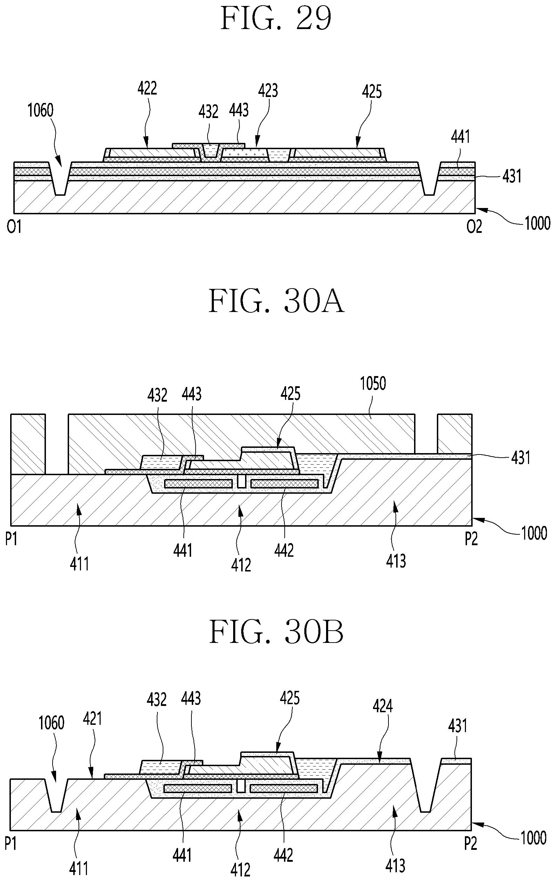

Specifically, as illustrated in FIG. 29, a second region 412 of an epitaxial layer 1005 may be patterned using a mask 1050, so that a plurality of semiconductor light-emitting device packages 350 each comprising one second semiconductor light-emitting device 422, one third semiconductor light-emitting device 423, one fifth semiconductor light-emitting device 425, and one sixth semiconductor light-emitting device 426 among a plurality of second semiconductor light-emitting devices 422, a plurality of third semiconductor light-emitting devices 423, a plurality of fifth semiconductor light-emitting devices 425, and a plurality of sixth semiconductor light-emitting devices 426 formed on a second region 412 of the epitaxial layer 1005 can be formed. At this time, a recess 1060 can be formed between the plurality of semiconductor light-emitting device packages 350.

As illustrated in FIG. 30A, the first region 411 and the third region 413 of the epitaxial layer 1005 may be patterned using the mask 1050, so that the first semiconductor light-emitting element 421 may be formed on the first region 411 of the epitaxial layer 1005, and the fourth semiconductor light-emitting element 424 may be formed on the third region 413 of the epitaxial layer 1005, as illustrated in FIG. 30B.

As illustrated in FIG. 31, the first region 411 of the epitaxial layer 1005 may be patterned using the mask 1050, so that the first semiconductor light-emitting element 421 may be formed on the first region 411 of the epitaxial layer 1005.

Meanwhile, referring to FIG. 32, a first electrode pad 445 and a second electrode pad 446 may be formed.

Specifically, as illustrated in FIG. 33, a metal film may be deposited on a wafer 1000 and then patterned to form a first electrode pad 445 and a second electrode pad 446.

The first electrode pad 445 may be formed on a region of the first semiconductor light-emitting element 421 by extending along the first direction X on a region of the third semiconductor light-emitting element 423. For example, one end of the first electrode pad 445 may be in contact with an upper surface of the second conductivity-type semiconductor layer 423c of the third semiconductor light-emitting element 423.

The second electrode pad 446 may be formed on a region of the fourth semiconductor light-emitting element 424 by extending along the first direction (-X) on a region of the sixth semiconductor light-emitting element 426. For example, one end of the second electrode pad 446 may be in contact with the upper surface of the second conductivity-type semiconductor layer 426c of the sixth semiconductor light-emitting element 426.

Thereafter, a third insulation layer (433 of FIG. 10A) may be formed on the wafer 1000 comprising the first electrode pad 445 and the second electrode pad 446. The third insulation layer 433 and the first insulation layer 431 may comprise the same insulating material, but are not limited thereto.

Meanwhile, as illustrated in FIG. 34, each of the plurality of semiconductor light-emitting element packages 350 may be separated from the wafer 1000.

A plurality of semiconductor light-emitting element packages 350 separated in this manner may be assembled on a display substrate 310 illustrated in FIG. 8 using a self-assembly process, so that a display device 300 may be manufactured.

The method of manufacturing a display device 300 using a self-assembly method based on a semiconductor light-emitting element (350 of FIG. 9A) according to an embodiment has been described in detail.

The semiconductor light-emitting element (350 of FIG. 9A) according to an embodiment may also be manufactured into a display device using a transfer method.

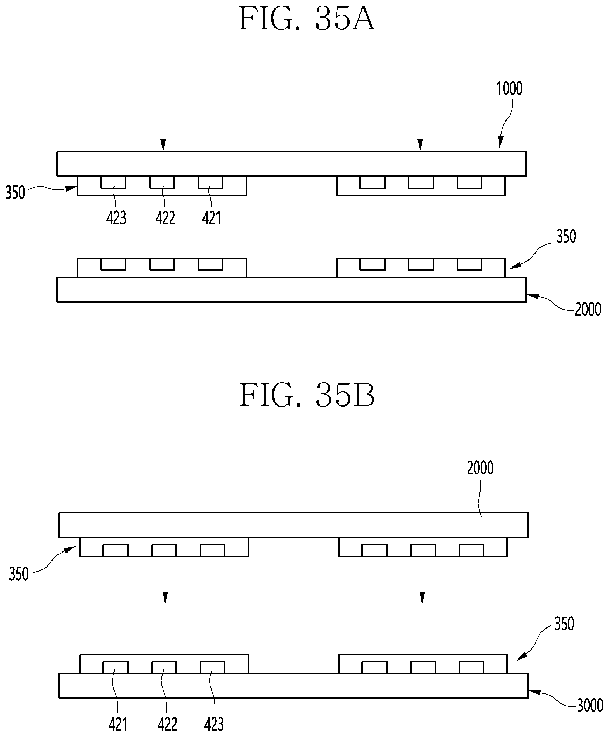

Hereinafter, a method of manufacturing a display device 301 using a transfer method will be described with reference to FIGS. 35A and 35B.

### [Transfer method]

FIGS. 35A and 35B illustrate a process of manufacturing a display device using a transfer method based on a semiconductor light-emitting element package according to an embodiment.

As illustrated in FIG. 35A, after the wafer 1000 illustrated in FIG. 32 is turned over, a plurality of semiconductor light-emitting element packages 350 on the wafer 1000 may be transferred onto the interposer, i.e., a temporary substrate 2000.

For example, an adhesive may be coated on an upper surface of the interposer 2000.

After the wafer 1000 comprising the plurality of semiconductor light-emitting element packages 350 is turned over, the wafer 1000 is pressed toward the interposer 2000, so that each of the plurality of semiconductor light-emitting element packages 350 may be attached to the interposer 2000 by the adhesive.

Thereafter, the laser is intensively irradiated between the wafer 1000 and the first conductivity-type semiconductor layers 421a and 424a of the first and fourth semiconductor light-emitting elements 421 and 424, respectively, so that the semiconductor light-emitting element package 350 may be separated from the wafer 1000. Accordingly, a plurality of semiconductor light-emitting element packages 350 may be transferred onto the interposer 2000.

As illustrated in FIG. 35B, after the interposer 2000 comprising the plurality of semiconductor light-emitting element packages 350 is turned over, the plurality of semiconductor light-emitting element packages 350 may be transferred onto the display substrate 3000 on the interposer 2000.

For example, an adhesive may be coated on the display substrate 3000.

After the interposer 2000 comprising the plurality of semiconductor light-emitting element packages 350 is turned over, the interposer 2000 may be pressed toward the display substrate 3000, so that each of the plurality of semiconductor light-emitting element packages 350 may be attached to the display substrate 3000 by an adhesive.

Thereafter, as the interposer 2000 moves in the upward direction, the plurality of semiconductor light-emitting element packages 350 on the interposer 2000 may be transferred onto the display substrate 3000. To this end, the adhesive strength of the adhesive on the display substrate 3000 may be greater than the adhesive strength of the adhesive on the interposer 2000.

Thereafter, the electrical connection of each of the plurality of semiconductor light-emitting element packages 350 may be made through a post-process, so that the display device 301 may be manufactured. The electrical connection means that the plurality of semiconductor light-emitting element packages 350 are electrically connected to the first signal line group 361 and the second signal line group 362 through the plurality of connection lines 370-1 to 370-4 and 371-1 to 371-3 illustrated in FIG. 7.

Meanwhile, the display device described above may be a display panel. That is, in the embodiment, the display device and the display panel may be understood to have the same meaning. In the embodiment, the display device in a practical sense may comprise a display panel and a controller (or processor) capable of controlling the display panel to display an image.

The above detailed description should not be construed as limiting in all respects and should be considered illustrative. The scope of the embodiment should be determined by reasonable interpretation of the appended claims, and all changes within the equivalent range of the embodiment are included in the scope of the embodiment.

### [Industrial Applicability]

The embodiment may be adopted in the display field for displaying images or information. The embodiment may be adopted in the display field for displaying images or information using a semiconductor light-emitting element. The semiconductor light-emitting element may be a micro-level semiconductor light-emitting element or a nano-level semiconductor light-emitting element.

For example, the embodiment may be adopted in a TV, signage, a smart phone, a mobile phone, a mobile terminal, a HUD for an automobile, a backlight unit for a laptop computer, and a display device for VR or AR.

## Claims

1. A semiconductor light-emitting element package, comprising:
a semiconductor substrate having a first region and a second region;
a first semiconductor light-emitting element on the first region of the semiconductor substrate;
a pair of assembling wirings on the second region of the semiconductor substrate; and
a second semiconductor light-emitting element and a third semiconductor light-emitting element on the pair of assembling wirings.

2. The semiconductor light-emitting element package of claim 1, wherein the semiconductor substrate shares a first conductivity-type semiconductor layer of the first semiconductor light-emitting element.

3. The semiconductor light-emitting element package of claim 1, wherein the semiconductor substrate has a third region, and the second region is positioned between the first region and the third region, and
comprising:
a fourth semiconductor light-emitting element on the third region of the semiconductor substrate; and
a fifth semiconductor light-emitting element and a sixth semiconductor light-emitting element on the pair of assembling wirings.

4. The semiconductor light-emitting element package of claim 3, wherein the first semiconductor light-emitting element and the fourth semiconductor light-emitting element are blue semiconductor light-emitting elements,
wherein the second semiconductor light-emitting element and the fifth semiconductor light-emitting element are green semiconductor light-emitting elements, and
wherein the third semiconductor light-emitting element and the sixth semiconductor light-emitting element are red semiconductor light-emitting elements.

5. The semiconductor light-emitting element package of claim 4, wherein the first semiconductor light-emitting element, the second semiconductor light-emitting element, and the third semiconductor light-emitting element constitute a first pixel, and
wherein the fourth semiconductor light-emitting element, the fifth semiconductor light-emitting element, and the sixth semiconductor light-emitting element constitute a second pixel.

6. The semiconductor light-emitting element package of claim 4, wherein the first semiconductor light-emitting element, the second semiconductor light-emitting element, and the third semiconductor light-emitting element constitute a pixel, and
wherein the fourth semiconductor light-emitting element, the fifth semiconductor light-emitting element, and the sixth semiconductor light-emitting element constitute a dummy pixel.

7. The semiconductor light-emitting element package of claim 4, wherein the third semiconductor light-emitting element and the sixth semiconductor light-emitting element are disposed between the second semiconductor light-emitting element and the fifth semiconductor light-emitting element.

8. The semiconductor light-emitting element package of claim 4, wherein the third semiconductor light-emitting element and the sixth semiconductor light-emitting element are symmetrical to each other with respect to a lengthwise direction of the pair of assembling wirings.

9. The semiconductor light-emitting element package of claim 8, wherein the third semiconductor light-emitting element is disposed on a first assembling wiring of the pair of assembling wirings, and
wherein the sixth semiconductor light-emitting element is disposed on a second assembling wiring of the pair of assembling wirings.

10. The semiconductor light-emitting element package of claim 8, wherein a first conductivity-type semiconductor layer of the third semiconductor light-emitting element and a first conductivity-type semiconductor layer of the sixth semiconductor light-emitting element are connected.

11. The semiconductor light-emitting element package of claim 4, comprising:
a first common pad commonly connected to a first upper side of each of the first semiconductor light-emitting element, the second semiconductor light-emitting element, and the third semiconductor light-emitting element; and
a first electrode pad extending horizontally in a direction of a second upper side of the first semiconductor light-emitting element on a second upper side of the third semiconductor light-emitting element.

12. The semiconductor light-emitting element package of claim 11, comprising:
a second common pad commonly connected to a first upper side of each of the fourth semiconductor light-emitting element, the fifth semiconductor light-emitting element, and the sixth semiconductor light-emitting element; and
a second electrode pad extending horizontally in a direction of a second upper side of the fourth semiconductor light-emitting element on a second upper side of the sixth semiconductor light-emitting element.

13. The semiconductor light-emitting element package of claim 12, wherein the first common pad and the second common pad are positioned diagonally.

14. The semiconductor light-emitting element package of claim 3, comprising:
a first insulation layer between the second region of the semiconductor substrate and the pair of assembling wirings;
a second insulation layer around each of the second semiconductor light-emitting element, the third semiconductor light-emitting element, the fifth semiconductor light-emitting element, and the sixth semiconductor light-emitting element; and
a third insulation layer on the first to sixth semiconductor light-emitting elements.

15. The semiconductor light-emitting element package of claim 3, wherein each of the second semiconductor light-emitting element, the third semiconductor light-emitting element, the fifth semiconductor light-emitting element, and the sixth semiconductor light-emitting element comprises a magnetic layer.

16. The semiconductor light-emitting element package of claim 1, wherein the pair of assembling wirings comprise a magnetic layer.

17. A display device, comprising:
a display substrate comprising a plurality of pixels;
a pair of first assembling wirings corresponding to each of the plurality of pixels;
a partition wall comprising an assembly hole on the pair of first assembling wirings;
a semiconductor light-emitting element package in the assembly hole;
wherein the semiconductor light-emitting element package comprises:
a semiconductor substrate having a first region and a second region;
a first semiconductor light-emitting element on the first region of the semiconductor substrate;
a pair of second assembling wirings on the second region of the semiconductor substrate; and
a second semiconductor light-emitting element and a third semiconductor light-emitting element on the pair of second assembling wirings.
